(19) Europäisches Patentamt / European Patent Office / Office européen des brevets

(11) **EP 4 668 179 B1**

(12) **EUROPEAN PATENT SPECIFICATION**

(45) Date of publication and mention
of the grant of the patent:
**05.08.2026 Bulletin 2026/32**

(21) Application number: **24182785.6**

(22) Date of filing: **18.06.2024**

(51) International Patent Classification (IPC):
*G06Q 10/04* (2023.01)    *H01M 10/42* (2006.01)
*B60L 58/12* (2019.01)    *B60L 58/16* (2019.01)
*G01R 31/392* (2019.01)    *G07C 5/08* (2006.01)

(52) Cooperative Patent Classification (CPC):
**G06Q 10/04; B60L 58/12; B60L 58/16;**
**G01R 31/392; G07C 5/0825;** H01M 2010/4271

(54) **COMPUTER SYSTEM AND METHOD FOR INDIRECT MEASUREMENT OF BATTERY DEGRADATION OF ELECTRIC VEHICLES**

COMPUTERSYSTEM UND VERFAHREN ZUR INDIREKTEN MESSUNG DER BATTERIEVERSCHLECHTERUNG VON ELEKTROFAHRZEUGEN

SYSTÈME INFORMATIQUE ET PROCÉDÉ DE MESURE INDIRECTE DE LA DÉGRADATION DE BATTERIE DE VÉHICULES ÉLECTRIQUES

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(43) Date of publication of application:
**24.12.2025 Bulletin 2025/52**

(73) Proprietor: **Tronity GmbH**
**68163 Mannheim (DE)**

(72) Inventors:
• **Echtermeyer, Eric**
**68163 Mannheim (DE)**

• **Born, Torsten**
**68163 Mannheim (DE)**

(74) Representative: **Fleuchaus & Gallo Partnerschaft mbB**
**Steinerstraße 15/A**
**81369 München (DE)**

(56) References cited:
**WO-A1-2021/194267    CN-A- 109 901 075**
**CN-A- 117 648 631    US-B2- 11 685 288**

# EP 4 668 179 B1

## Description

### Technical Field

The present invention generally relates to method and system for measurement of a physical parameter, and in particular, relates to methods, computer program products and systems for indirect measurement of battery degradation of electric vehicles.

### Background

The degradation of batteries used in electric vehicles (EV) is typically described by complex models which try to simulate the impact of various influencing factors such as cell/cycle ageing, cell operation, temperature, etc. on a battery's performance. The lifetime capacity of a battery is referred to as its state of health (SoH). New batteries have a 100% SoH, which inevitably reduces over time. To determine the degradation of an EV battery different prior art methods are known. One commonly used method is cycle testing which involves charging and discharging the battery repeatedly. By observing differences in battery capacity, the battery degradation value can be calculated. However, this method usually requires additional hardware to monitor and manage the battery testing process. Thus, it is both time-consuming and expensive, and can usually only be carried out in a laboratory environment. Furthermore, the test conditions may not accurately reflect real-world usage, leading to potential discrepancies in degradation values. Another known approach to determine battery degradation is using electrochemical models that predict degradation by simulating the chemical and physical processes within the battery. While offering high accuracy, this approach is computationally intensive and requires extensive knowledge of battery chemistry, making it impractical for everyday EV drivers who lack the necessary expertise and computational resources to implement these models. A third known approach is monitoring changes in voltage and current during the battery's operation. However, accurate measurement of these parameters typically requires direct access to the battery data, often necessitating sophisticated and sometimes proprietary monitoring systems. Thus, it needs additional software and hardware to determine the battery degradation.

### Summary

Hence, there is a need for providing a measurement method/system which allows to determine the degradation of an EV battery without a need to directly measure respective technical parameters of the battery. This technical problem is solved by the herein disclosed approach for indirect measurement of battery degradation of a particular electric vehicle. The herein disclosed invention for indirect measurement of battery degradation of electric vehicles overcomes the limitations of the above-described prior art methods. It does not require any additional hardware, direct access to the battery, or specialized equipment. By utilizing existing vehicle data, the herein disclosed approach estimates battery degradation without the need for intrusive monitoring or complex simulations. Thus, it simplifies the battery degradation assessment, making it accessible and practical for all EV drivers. Accessing and monitoring battery degradation is not only relevant for individual EV drivers but also for companies that operate fleets, as well as external providers such operators of virtual power plants. Based on a system to easily and quickly determine battery degradation, early warning systems can be provided, leading to reduced safety risks, for example in cases where the EV may unexpectedly stop on the road because the battery discharged faster than expected. This enables continuous monitoring of battery degradation, entirely independent of additional hardware and potential appointments at a workshop by using only physical parameters provided by the EV during its charging runs without relying on additional hardware. Thus, there is no need for direct measurements of the battery. A charging run, as used hereinafter, is a single loading procedure (or charging process) for the battery of the EV. The single loading procedure is started, when the battery is connected to a charging station and terminated when the battery is disconnected again, irrespective of the charging time or charging levels reached.

Thereby, the history of charging run parameters (including previous charging runs and the current charging run) is stored in a charging run database storing charging parameters of each charging run. Such parameters include the charging level of the battery and a corresponding vehicle range related parameter value together with a corresponding odometer reading for the respective charging run, or a corresponding time point for the respective charging run. Further parameters characterizing a charging run, such as kWh_added (i.e., kWh charged since last charging timestamp), the electrical charging power (kW representing the charging speed) at different time points, AC/DC (i.e., charging run with alternating current or direct current) or voltage/amperage may also be stored in the charging run database. It is to be noted that during a charging run the vehicle does not move. Therefore, the odometer reading is constant during the charging run. With regard to the corresponding time point, the starting time of the charging run or the end time can be used as a time stamp which uniquely identifies the respective charging run in cases where only one parameter set is used per charging run. It is also possible that, for each charging run, a plurality of parameter sets is stored which reflects the charging behavior of the EV during the respective charging run. For example, the system may store the parameter values for predefined

2

charging levels (e.g., 25%, 50%, 75%, 100%) per charging run, or for predefined range related parameter values. The current battery degradation in combination with the historic battery degradation over time even allows for predictions of the future battery degradation by taking into account seasonal influences such as the temperature at various times of the year.

In one embodiment, a computer system for indirect measurement of battery degradation of a particular EV receives a plurality of parameter sets associated with a plurality of completed charging runs of the vehicle. A completed charging run, as used herein, does not mean that the EV has been charged up to 100%. Rather, a charging run is completed when the charging process is terminated, irrespective of the charging level reached at the end of the charging run. For example, a charging process may be started at a charging level 50% and terminate at a charging level 55%. If the vehicle starts driving any time after this charging termination, this charging run qualifies as a completed charging run according to the above definition. The computer system is communicatively coupled with a respective data source (charging run database) via an interface which allows exchange of data. Thereby, multiple parameter sets may be associated with a single charging run. That is, parameter sets associated with a particular charging run may characterize different stages of said charging run. In other words, parameter sets associated with the particular charging run can illustrate the development of charging levels and their associated range related parameter values during the particular charging run. Thereby, a particular parameter set for a particular charging run comprises at least: a charging level of the battery and a vehicle range related parameter value. Further, it comprises the corresponding odometer reading of the vehicle or the corresponding time point (or both) associated with the particular charging run. Advantageously, the vehicle range related parameter value is the vehicle range value provided by the EV. Alternatively, a number of kWh being charged for achieving said range value may be used, or voltage and amperage and time used for the charging run to charge said number of kWh. Advantageously, the received parameter sets cover a minimum number of charging runs including the recent charging history of the EV.

The system now groups the received vehicle range related parameter values by corresponding charging levels within grouping intervals. That is, for each charging level which occurred during a particular grouping interval, all vehicle range related parameter values which were received for a particular charging level with regard to this particular grouping interval are assigned to this particular charging level. As a consequence, a minimum number of one charging run per grouping interval is needed. Grouping intervals can be predefined odometer reading intervals during which the respective charging runs occurred, or the grouping intervals can be predefined time intervals in which the respective charging runs occurred. For example, a new grouping interval may start every 1000 km (e.g., 0km - 999km, 1000km - 1999km, ...). In the alternative implementation, the predefined time intervals for grouping may correspond to the months of the year (e.g., 11/2023, 12/2023, 01/2024, ...). Of course, other interval ranges may be suitable dependent on the annual mileage of the EV and the associated number of charging runs. In other words, within a grouping interval (e.g., 0km - 999 km), charging levels which were reached during a respective charging run within this grouping interval get assigned all the corresponding vehicle range related parameter values which were determined for the respective charging levels during this grouping interval. For example, the board computer of the vehicle can estimate an expected driving range for the vehicle based on a current charging level of the battery. Advantageously, value pairs of "charging level | vehicle range related parameter value" are stored in 1% steps of the charging level in the charging run database. This allows also meaningful analysis of very short completed charging runs (e.g., from 50% to 55% charging level). Alternatively, also value pairs with a charging level distance of 2% to 5% (or even larger) may be used by the grouping step. The density of available data points characterizing a charging run may depend on the vehicle type and may also depend on the charging speed. Typically, the vehicle manufacturer defines the intervals at which new data points are created during a charging run. In situations with a high charging speed, it may occur that certain charging levels are skipped. The herein disclosed approach is independent of the data point density as long as at least one data point exists for each grouping interval.

The system then determines, for each of the plurality of completed charging runs, a maximum value of the vehicle range related parameter obtained for associated charging levels across all grouping intervals. That is, in a situation where multiple grouping intervals include a same charging level value, the maximum vehicle range related parameter value amongst vehicle range related parameter values assigned to said same charging level value across all such grouping intervals is determined.

Further, for each charging level, a first measure of central tendency of the associated vehicle range related parameter values in each grouping interval is computed. Advantageously, the first measure of central tendency is the median of the associated vehicle range related parameter values in each grouping interval. Alternatively, the mean or the mode (value appearing most often in the set) of the associated vehicle range related parameter values may be used.

The results of the previous two steps are now used to determine intermediate battery degradation values. For this purpose, the system computes, for each associated charging level in each grouping interval, the ratio of the respective computed first measure of central tendency to the respective maximum value of vehicle range related parameter values. Then, the intermediate battery degradation value for each charging level within the respective grouping interval is determined based on said ratios. In more detail, each computed ratio is subtracted from '1' resulting in a corresponding intermediate battery degradation value for each charging level for the respective grouping interval.

In a next step, battery degradation values are computed for each grouping interval based on respective intermediate battery degradation values in that, for each grouping interval, a second measure of central tendency of all intermediate battery degradation values is computed across all charging levels in the respective grouping interval. These second measure of central tendency values correspond to the battery degradation values for each grouping interval. It is to be noted that the battery degradation values computed in this step are derived from parameter values provided by the EV without any need for direct measurements of battery parameters. It does not only allow to determine the current degradation value of the battery but also provides the information how the battery degradation has evolved over time in the past. This information is useful to even provide predictions of the battery degradation for assessment time intervals in the future. For example, a person skilled in the art may use linear regression or more complex algorithms in the field of time series forecasting to obtain such predictions.

In one embodiment, the method may include an optional data cleaning step which is applied to the received parameter steps before the grouping step. The data cleaning step removes outlier and/or data of bad quality from the received parameter values by applying a data cleaning method. Examples of suitable data cleaning methods involve identifying or flagging data for cleaning using one or more of the following methods: distance metrics comprising Mahalanobis Distance and Z-Score for outlier detection, estimation methods comprising Minimum Covariance Determinant estimator for determining multivariate outliers, and algorithms comprising Local Outlier Factor for multivariate outlier detection and clustering algorithms comprising DBSCAN and k-Means for group-based outlier detection.

In one embodiment, the computer-implemented method comprises further optional steps for determining a state-of-health score of the battery of the particular electric vehicle based on the previously determined battery degradation values. Also, the state-of-health score is determined without any direct measurement of battery parameters. Rather, the degradation values of the particular EV are compared to corresponding fleet vehicle battery degradation values which were determined for electric fleet vehicles of the same type/variant as the particular EV, and using the same indirect measurement method as for the particular EV. For example, such fleet vehicle battery degradation values for a plurality of electric fleet vehicles may be stored in a respective data storage each time after the degradation value for a respective fleet EV is determined (i.e., after the completion of a charging run).

Then, fleet vehicle battery degradation values are obtained (e.g., from said data storage) for a plurality of electric fleet vehicles having a vehicle type corresponding to the particular electric vehicle. That is, the comparison is made only between EVs of the same type (same vehicle type, same battery capacity, same engine power, etc.). Further, only fleet vehicle battery degradation values are obtained which are associated with odometer readings below a predefined threshold indicating a near-perfect health of the respective battery. Typically, a useful threshold is the odometer readings is in the order of 2500 km.

In a next step, the obtained fleet vehicle battery degradation values belonging to respective seasonal time intervals are aggregated into a single value - an aggregated fleet vehicle battery degradation value - for the respective seasonal time interval. Thereby, each seasonal time interval represents a corresponding seasonal period of the year. Advantageously, the seasonal time intervals correspond to the months of the year. Alternatively, the weeks of the year (in case there are charging runs occurring during each week) or groups of consecutive weeks, or time intervals representing the seasons of the year (e.g., winter, spring, summer, autumn) may be used. For example, all fleet vehicle battery degradation values of EVs of a first vehicle type measured for a particular month with odometer readings below said threshold are aggregated into said month and a first measure of central tendency fleet degradation value is determined for each seasonal time interval. In other words, for each seasonal time interval, an aggregated seasonal fleet degradation value is determined which is representative for all EVs in the fleet of the same type as the particular EV and having a near-perfect-health battery.

A predefined assessment time interval for determining the state-of-health score has a length which is a multiple of the length of a seasonal time interval. For example, the assessment time interval may have the length of a predefined number of consecutive months or weeks. For the particular vehicle, a measure of central tendency battery degradation value is computed for said assessment time interval. Advantageously, the assessment time interval includes the three months prior to the date of the charging run associated with the current battery degradation value in case the current state-of-health is to be determined. A skilled person may use any other appropriate assessment time interval prior to the time point of the charging run for which the state-of-health is to be determined. The computed measure of central tendency battery degradation value is representative of the battery degradation of the particular vehicle during the assessment time interval.

A similar computation is then performed for the plurality of electric fleet vehicles by computing a second measure of central tendency fleet degradation value for the assessment time interval. The second measure of central tendency fleet degradation value is based on the first measure of central tendency fleet degradation values of the respective seasonal time intervals and is therefore representative of the fleet battery degradation during the assessment time interval. That is, the battery degradation of the particular vehicle during the assessment time interval can be compared with the respective fleet battery degradation.

This comparison is made by determining the relative distance between the measure of central tendency battery degradation value and the second measure of central tendency fleet degradation value as a state-of-health score of the battery of the particular electric vehicle.

In one embodiment, a computer program product is provided for indirect measurement of battery degradation of a particular electric vehicle, that when loaded into a memory of a computing device and executed by at least one processor of the computing device executes the steps of the herein disclosed computer-implemented method.

In one embodiment, a computer system is provided for indirect measurement of battery degradation of a particular electric vehicle. The system includes functional modules implemented by computer-readable instructions, which can be instantiated by the system at runtime to perform the functions performed by herein disclosed computer-implemented method.

In more detail, the system has an interface configured to receive a plurality of parameter sets associated with a plurality of completed charging runs of the vehicle. Thereby, a particular parameter set for a particular charging run comprises at least: a charging level of the battery, a vehicle range related parameter value, and at least one of a corresponding odometer reading of the vehicle or a corresponding time point, for the particular charging run.

A grouping module of the system is adapted to group charging runs with their respective charging levels by corresponding grouping intervals, and grouping the vehicle range related parameter values by corresponding charging levels. In a first alternative, the grouping intervals are predefined odometer reading intervals during which the respective charging runs occurred. In a second alternative, the grouping intervals are predefined time intervals in which the respective charging runs occurred.

A maximum range module of the system is adapted to determine for each of the plurality of completed charging runs, a maximum value of the vehicle range related parameter obtained for associated charging levels across all grouping intervals. In one implementation, the maximum value is the absolute maximum of the vehicle range related parameter obtained for associated charging levels across all grouping intervals. In an alternative implementation, the maximum value is a "reduced maximum" where the maximum value is obtained by using an attenuation factor in that a maximum value is selected which is below the absolute maximum value in the grouping interval. For example, in case there are ten values in a respective grouping interval, the system may select not the highest value but the value which is closest to the highest value. Other selection rules for the "reduced maximum" value may be used, too. This implementation can serve as a further data cleaning method where the impact of poor-quality data values and very high data values is reduced.

A measure of central tendency module of the system is adapted to compute, for each charging level, a first measure of central tendency of the associated vehicle range related parameter values in each grouping interval.

An intermediate battery degradation module of the system is adapted to compute, for each associated charging level in each grouping interval, the ratio of the respective computed first measure of central tendency to the respective maximum value of vehicle range related parameter values, and to determine an intermediate battery degradation value by grouping interval for each charging level based on said ratios.

A battery degradation module of the system is adapted to compute, for each grouping interval, a second measure of central tendency of all intermediate battery degradation values across all charging levels in the respective grouping interval resulting in the battery degradation values for each grouping interval.

In one embodiment, the system further includes a data cleaning module adapted to remove outlier and/or data of bad quality from the received parameter values by applying a data cleaning method before providing cleaned data to the grouping module.

In one embodiment, the system further includes a state-of-health of battery module adapted to:

- obtain fleet vehicle battery degradation values for a plurality of electric fleet vehicles having a vehicle type corresponding to the particular electric vehicle, wherein the obtained fleet vehicle battery degradation values are associated with odometer readings below a predefined threshold indicating a near-perfect state-of-health of the respective battery;

- aggregate obtained fleet vehicle battery degradation values belonging to respective seasonal time intervals wherein each seasonal time interval represents a corresponding season of the year (where typical climate conditions prevail), by determining a first measure of central tendency fleet degradation value for each seasonal time interval;

- compute, for the particular vehicle, a measure of central tendency battery degradation value for an assessment time interval comprising a plurality of seasonal time intervals;

- compute, for the plurality of electric fleet vehicles, a second measure of central tendency fleet degradation value for the assessment time interval, wherein the second measure of central tendency fleet degradation value is based on the first measure of central tendency fleet degradation values of the respective seasonal time intervals; and

- determine the relative distance between the measure of central tendency battery degradation value and the second measure of central tendency fleet degradation value as a state-of-health score of the battery of the particular electric vehicle.

Further aspects of the invention will be realized and attained by means of the elements and combinations particularly depicted in the appended claims. It is to be understood that both, the foregoing general description and the following detailed description are exemplary and explanatory only and are not restrictive of the invention as described.

## Brief Description of the Drawings

FIG. 1A shows a simplified diagram of an embodiment of a computer system for indirect measurement of battery degradation of a particular electric vehicle;
FIG. 1B illustrates further optional modules of the computer system adapted for determining a state-of-health of the battery of the particular electric vehicle;
FIG. 2A is a simplified flowchart of a computer-implemented method for indirect measurement of battery degradation of the particular electric vehicle according to an embodiment;
FIG. 2B illustrates further optional steps of the computer-implemented method for determining the state-of-health of the battery of the particular electric vehicle;
FIG. 3 illustrates an example with odometer grouping intervals with values characterizing a plurality of charging runs of a particular vehicle;
FIGs. 4A to 4D illustrate poor data quality examples for charging run parameters obtained from real charging runs for four vehicles of different vehicle types;
FIG. 5 illustrates an example of monthly degradation box plots for a virtual electric vehicle fleet with vehicles of a same vehicle type;
FIG. 6 illustrates a comparison of degradation value accuracy achieved by the herein disclosed approach with degradation value accuracy achieved with a prior art approach;
FIG. 7 illustrates an example of identifying data for data cleaning using Mahalanobis Distance; and
FIG. 8 is a diagram that shows an example of a generic computer device and a generic mobile computer device, which may be used with the techniques described here.

## Detailed Description

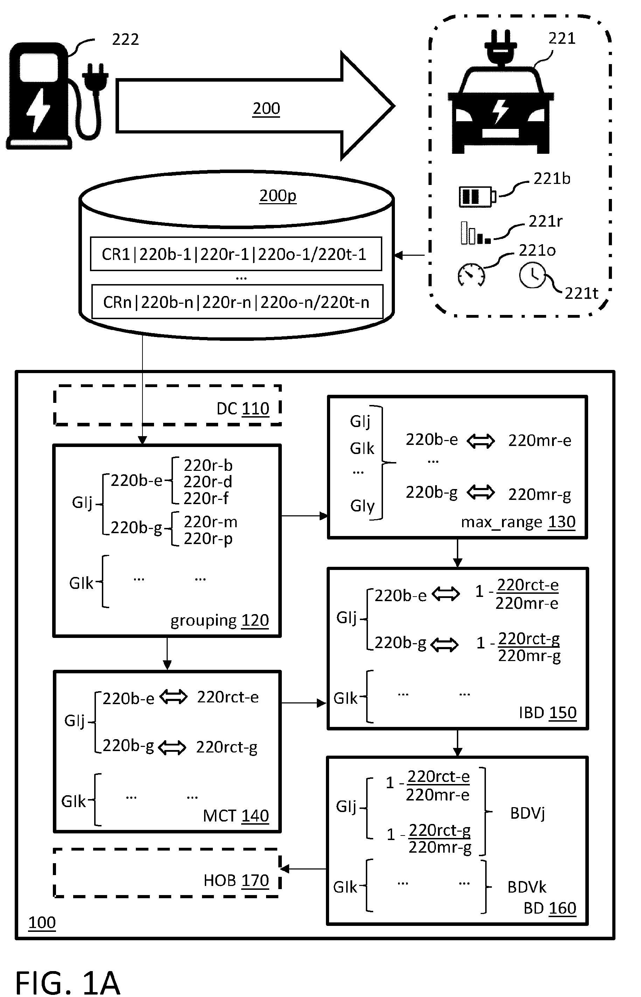

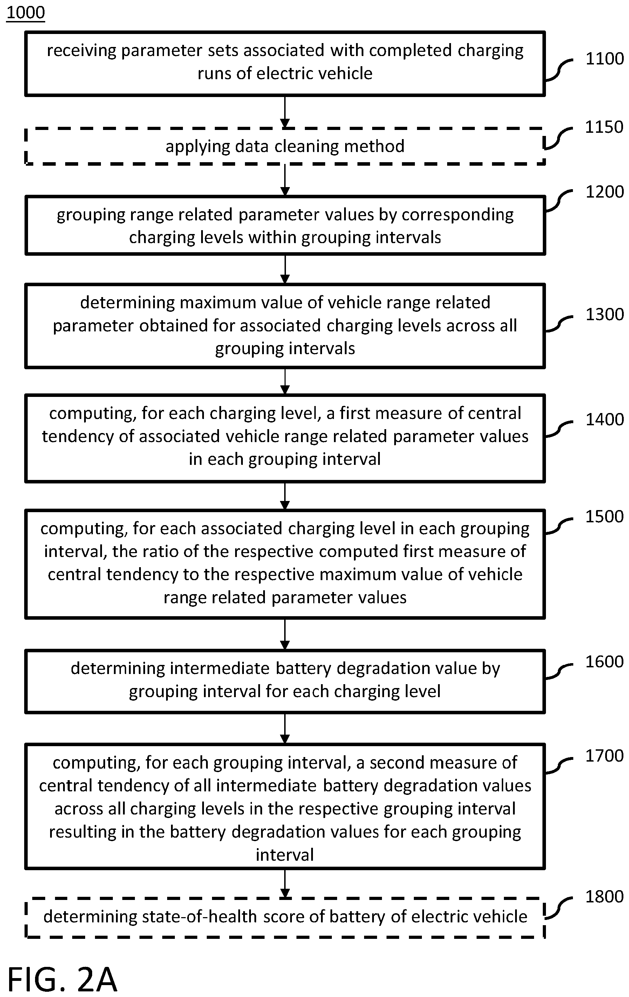

FIG. 1A shows a simplified diagram of an embodiment of a computer system 100 for indirect measurement of battery degradation of a particular electric vehicle 221 (EV 221). FIG. 2A is a simplified flowchart of a computer-implemented method 1000 for indirect measurement of battery degradation of the particular electric vehicle. Method 1000 can be executed by system 100. For this reason, the system 100 in FIG. 1A will be described in view of the flow chart of method 1000.

EV 221 has performed a plurality 200 of charging runs CR1 to CRn including a current (or most recent) charging run. The charging power for the plurality 200 of charging runs may be provided by one or more charging stations 222. In a realistic charging scenario, many different charging stations are used over time for charging the battery of EV 221. These charging stations may be of different types including slow charging stations (e.g., private 11 kW charging stations) and fast charging stations (e.g., 300 kW charging stations of electricity providers).

During a particular charging run CR1 to CRn, a charging run database 200p stores charging run parameters provided by EV 221 during each charging run. The notation CR*, as used herein, relates to any parameter record associated with a particular charging run. The charging run parameters include at least a current charging level 221b of the EV battery and a corresponding a vehicle range related parameter value 221r. Further, at least one of a corresponding odometer reading 221o or a corresponding time point 221t is provided by EV 221, wherein the corresponding odometer reading/time point indicates the odometer reading/time point associated with the respective parameter value pair "charging level | vehicle range related parameter value" (i.e., the odometer reading/time point at which the parameter value pair was measured). For each charging run CR*, a single characteristic charging run parameter record may be stored in database 200p (e.g., a dataset with the values at the end of the charging run). However, advantageously, database 200p continuously stores charging run parameter sets also during each charging run. For example, a parameter value pair may be stored for each additional percent of the charging level (e.g., ..., 26%, 27%, 28%, ...). Larger intervals may be used, too (e.g., ..., 26%, 28%, ...). The higher the number of parameter value pairs stored in database 200p the better the accuracy of the herein disclosed indirect measurements results.

Two exemplary parameter value pairs 220b-1|220r-1 and 220b-n|220r-n are shown in FIG. 1A for a first charging run CR1 and a most recent (current) charging run CRn. As explained above, there can be multiple records associated with multiple parameter value pairs for each of the charging runs (e.g., for each charging level percentage reached during the respective charging run). Further, database 200p stores for each data record CR* at least one of the corresponding odometer reading 220o-1, 220o-n and the corresponding time point 220t-1, 220t-n. All parameter sets (records comprising parameter value pairs with a corresponding odometer reading or time point) stored for a particular charging run define a completed charging run - independent of the charging level reached at the end of the charging run. Even if a charging run would be terminated already at a charging level of 20% (or even less) it would count as a completed charging run.

System 100 is communicatively coupled with database 200p such that the data records CR* associated with completed charging runs 200 of EV 221 are received 1100 by system 100 via a respective interface. Interfaces for the exchange of data between computer systems are well known in the art.

A grouping module 120 of system 100 is adapted to group 1200, within respective grouping intervals GI*, the vehicle range related parameter values 220r-* by corresponding charging levels 220b-* belonging to a corresponding grouping interval. In a first alternative, the grouping intervals GI* are predefined odometer reading intervals during which the respective charging runs occurred. In a second alternative, the grouping intervals are predefined time intervals in which the respective charging runs occurred. In the example of FIG. 1A, two consecutive grouping intervals GIj and GIk are shown. In a real-world application, the number of grouping intervals can become large dependent on the kilometers driven by the EV (or its age). In the example, it is assumed that for the grouping intervals the odometer readings are used. For example, GIi may be the interval [5000 km, 5999 km] and GIk may be the interval [6000 km, 6999 km]. Equally sized intervals may precede GIj and succeed GIk. The grouping is shown only for GIj in the example. In the example, two charging levels 220b-e and 220b-g occurred in GIj. In a real-world example with continuous charging level monitoring during each charging run in percentage steps, the number of charging level values in the grouping interval may easily be between 90 and 100. It is to be noted that charging levels provided by an EV are always integer values. The corresponding vehicle range related parameter values (across all charging runs in the grouping interval) are then grouped by the charging level. In the example, during grouping interval GIj, charging level 220b-e was reached in three charging runs with corresponding vehicle range related parameter values 220r-b, 220r-d, 220r-f. Charging level 220b-g was reached in two charging runs with corresponding vehicle range related parameter values 220r-m, 220r-p. The same grouping algorithm is applied to all grouping intervals GI*.

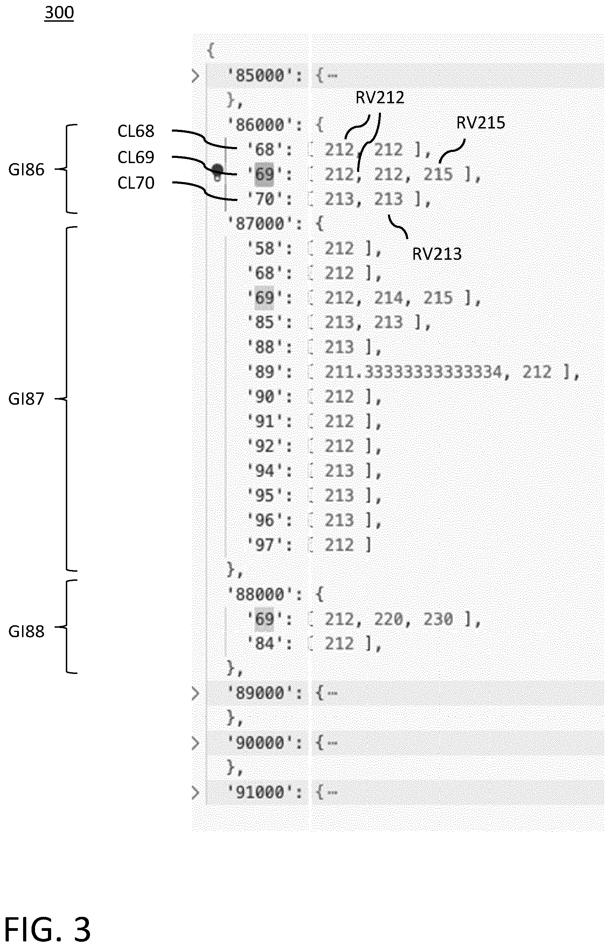

Turning briefly to FIG. 3, a real-world grouping result 300 is shown for a particular EV with odometer reading grouping intervals. The grouping intervals with the interval starting at 85000 km and end with interval starting at 91000 km. Details are shown for the grouping intervals GI86, GI87, GI88 starting with 86000 km, 87000 km and 88000 km with the charging levels indicated by two-digit numbers in inverted commas and corresponding range values of the EV in square brackets. For the grouping interval GI86, for the charging level CL68 (68%) two times the range value RV212 (212 km) was reached in the charging runs which occurred during said grouping interval. For the charging level CL69 (69%), two times the range value RV212 (212 km) and once the range value RV215 (215 km) were reached. For the charging level CL70 (70%), two times the range value RV213 (213 km) was reached. The other grouping intervals GI87, GI88 are to be read in the same way. For example, in grouping interval GI87, significantly more charging runs occurred than in grouping intervals GI86 and GI88. In GI88, the data points for charging level 69% show a higher variability than in the other charging intervals.

Turning back to FIG. 1A, a maximum range module 130 of system 100 is adapted to determine 1300 for each of the plurality 200 of completed charging runs, a maximum value 220mr-* of the vehicle range related parameter obtained for associated charging levels across all grouping intervals GI*. In the example, for the charging level 220b-e a maximum value 220mr-e is determined across all grouping intervals GIj to GIy. For charging level 220b-g a maximum value 220mr-g is determined across all grouping intervals GIj to GIy.

A measure of central tendency module 140 (MCT) of system 100 is adapted to compute 1400, for each charging level, a first measure of central tendency 220rct-* of the associated vehicle range related parameter values in each grouping interval GI*. In the example, the first measure of central tendency is the median of the vehicle range related parameter values associated with a particular charging level in a respective grouping interval. Alternatively, the mean may be used as well. Theoretically, the mode could also be used. However, for achieving good results with the mode, the same vehicle range related parameter values need to occur multiple times for a respective charging level. In a practical application, this usually does not happen very often. In the example, in grouping interval GIj, the median of the vehicle range related parameter values associated with charging level 220b-e is median value 220rct-e, and the median of the vehicle range related parameter values associated with charging level 220b-g is median value 220rct-g.

An intermediate battery degradation module (IBD) 150 of system 100 is adapted to compute 1500, for each associated charging level 220b-* in each grouping interval GI*, the ratio of the respective computed first measure of central tendency to the respective maximum value of vehicle range related parameter values, and to determine 1600 an intermediate battery degradation value by grouping interval for each charging level based on said ratios. In the example, for charging level 220b-e in grouping interval GIj, IBD 150 computes the ratio of the respective median 220rct-e (obtained by MCT 140) to the corresponding maximum range value 220mr-e (obtained by module 130). The intermediate battery degradation for charging level 220b-e in grouping interval GIj is then determined by subtracting the computed ratio 220rct-e/220mr-e from '1', indicating a preliminary degradation assessment for each charging level 220b-e which is used later for calculating the final degradation values for each grouping interval GIj. Similarly, the intermediate battery degradation for charging level 220b-g in grouping interval Glj is determined by subtracting the computed ratio 220rct-g/220mr-g from '1'. The same computations are applied for all charging levels in all respective grouping intervals.

Finally, a battery degradation value is computed by a battery degradation module (BD) 160 of system 100. BD 160 is adapted to compute 1700, for each grouping interval, a second measure of central tendency of all intermediate battery degradation values across all charging levels in the respective grouping interval GI* resulting in the battery degradation values BDV* for each grouping interval. In the example, the second measure of central tendency is the median of intermediate battery degradation values across all charging levels in the respective grouping interval GI*. For grouping interval Glj, the median BDVj is determined from all respective intermediate degradation values (1- 220rct-e/220mr-e, 1 - 220rct-g/220mr-g, ...). It is clear for a person skilled in the art that the median can only be determined for grouping intervals with at least three charging levels, which is typically the case in a real-world charging scenario. However, if only two intermediate battery degradation values are available for a particular grouping interval, BD 160 may still use the mean value as the second measure of central tendency. The same is true for the first measure of central tendency in MCT 140.

In cases where the charging run parameters for a particular EV are of poor quality, system 100 may further include a data cleaning module (DC) 110 which applies 1150 a data cleaning method to the received charging run parameters from database 200p prior to the processing by the grouping module 120. Optional DC 110 is adapted to remove outlier and/or data of bad quality from the received parameter values by applying a data cleaning method before providing cleaned data to the grouping module 120. Data cleaning methods are known in the art and include methods for identifying data requiring cleaning, such as distance metrics like Mahalanobis Distance and Z-Score, estimation methods like Minimum Covariance Determinant estimator, Multivariate Outlier Detection Algorithms comprising Local Outlier Factor, and Clustering Algorithms comprising DBSCAN and k-Means.

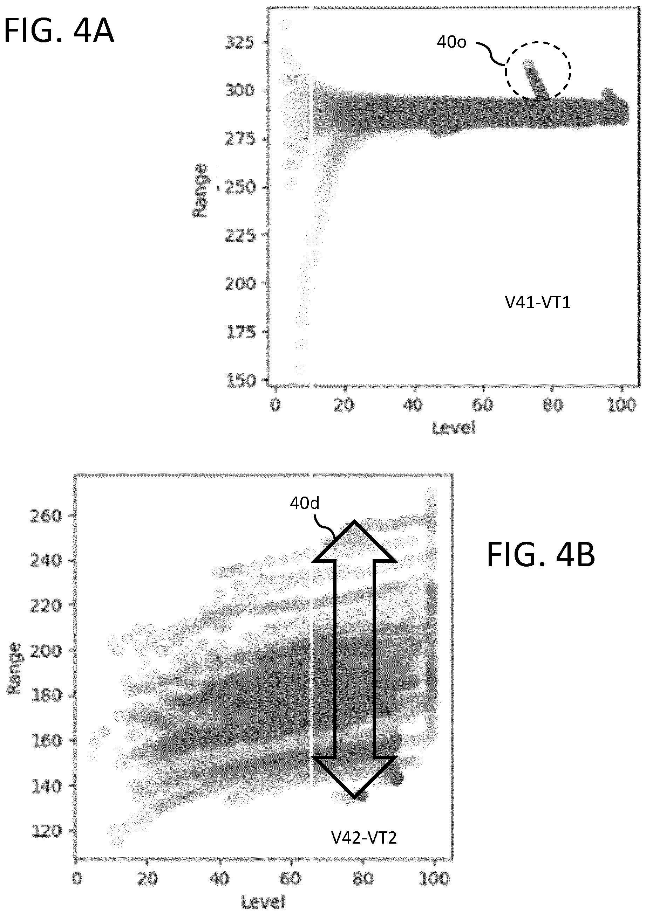

FIGs. 4A to 4B show example of poor data quality for different EVs of different vehicle types. In the examples, dark grey bullets (e.g., FIG. 4A: level = 80, range = 290) represent value pairs with many data points whereas light grey bullets (e.g., FIG. 4A: level = 10, range = 200) represent value pairs with only a few data points. In particular, the maximum range parameter is prone to outliers. A problem is, how to set this parameter correctly. There can be huge differences between data points. In some cases, an appropriate data cleaning method can be useful to address the data quality problem.

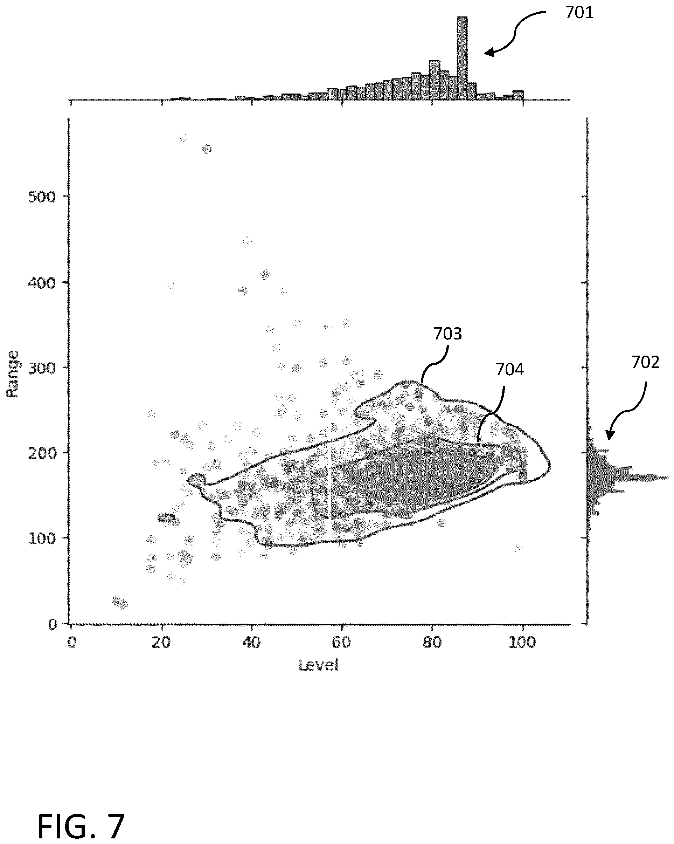

In the example of FIG. 4A, vehicle range values for respective charging levels are shown for a first electric vehicle V41-VT1 of a first vehicle type. The data points show a series of outliers in the area indicated by the dashed circle 40o. In the example of FIG. 4B, vehicle range values for respective charging levels are shown for a second electric vehicle V42-VT2 of a second vehicle type. Huge differences in the maximum range values for each charging level can be observed as indicated by the double arrow 40d. For both examples, a data cleaning method using a distance metrics such as Mahalanobis Distance can be used for filtering the data points and increasing the data quality of the charging run parameters for later processing. FIG. 7 illustrates an example of how Mahalanobis Distance can be used to filter out outliers from the data points. In this example, 701 and 702 visualize the distribution of range values and charging levels as histograms, respectively. As shown, the plotted data points are not consistent and suffer from high variance. By applying data cleaning methods to identify outliers by using, for example, distance metrics such as the Mahalanobis Distance, inconsistent data and outliers can be excluded. 703 and 704 demonstrate exemplary thresholds for the Mahalanobis distance, where 704 shows a stricter threshold, leading to more excluded data points. A person skilled in the art can determine the threshold based on a confidence level and chi-square distribution.

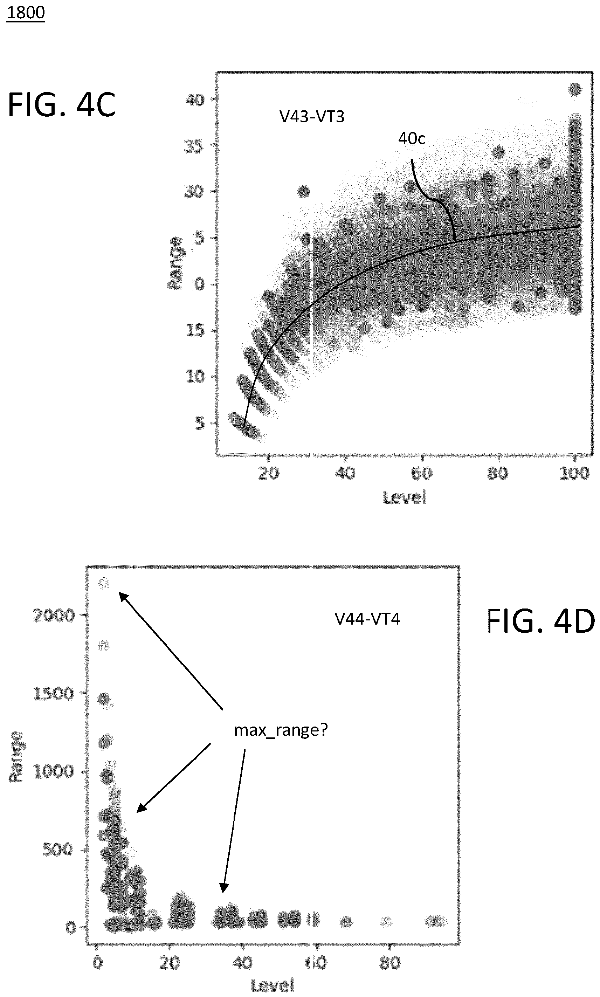

In the example of FIG. 4C, vehicle range values for respective charging levels are shown for a third electric vehicle V43-VT3 of a third vehicle type. The data points for V43-VT3 show a curve shape 40c. How to handle such curve shaped data with regard to determining the maximum range parameter. In the example of FIG. 4D, vehicle range values for respective charging levels are shown for a fourth electric vehicle V41-VT1 of a fourth vehicle type. It is difficult to decide which data point should be used to determine the maximum range value max_range for said vehicle. In particular, the range values for very low charging levels would lead to misleading results. The herein proposed approach uses two-stage measures of central tendency to overcome this data quality issue. For example, by using the median of medians, values at the extreme ends of the measured values are filtered out (i.e., not taken into account). In this regard, the median measure of central tendency is more advantageous than the mean measure of central tendency.

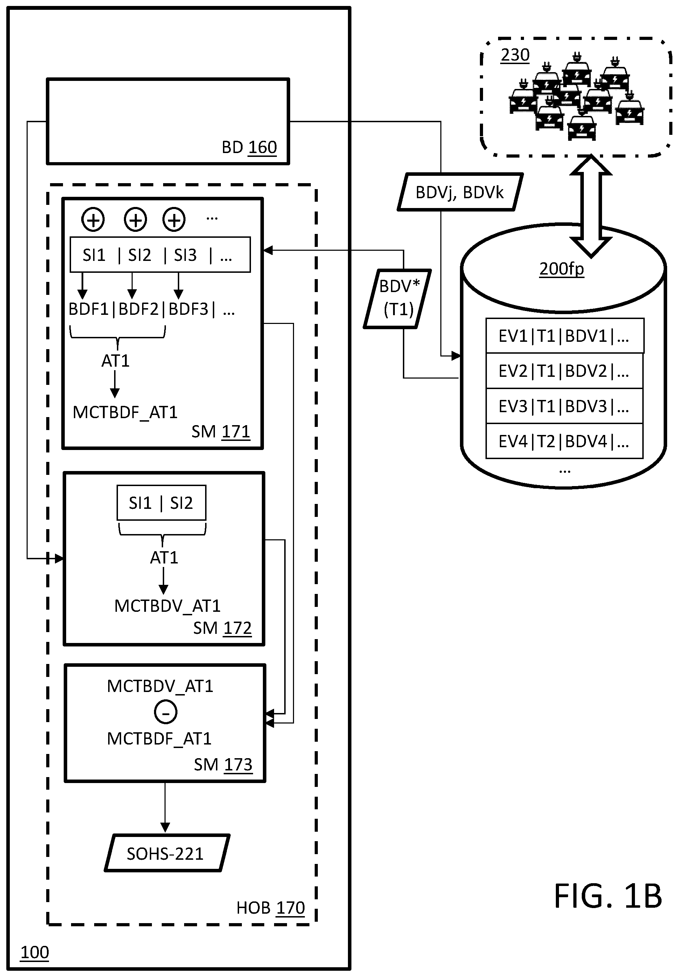

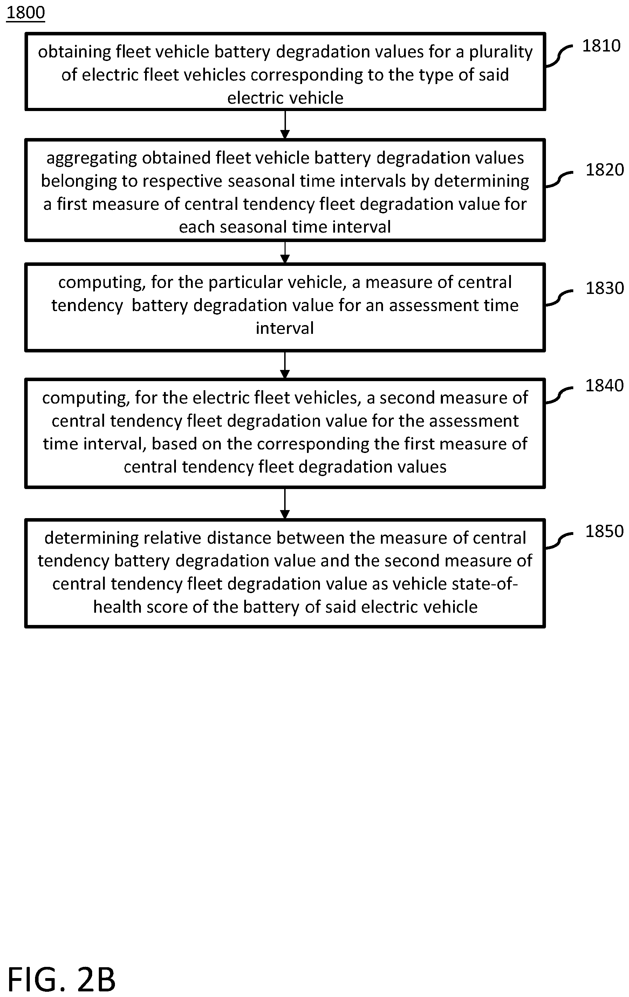

Based on the battery degradation determined for the EV 221 (cf. FIG. 1A), system 100 can be further extended with an optional state-of-health module (HOB) 170 to determine 1800 (cf. FIG. 2A) the state-of-health of the EV's battery. These sub-modules of HOB 170 are shown in FIG. 1B as modules 171 to 173, which together can be seen as implementing the HOB 170 for assessing the health of the battery. The computer-implemented steps 1800 which are performed by the optional submodules of HOB 170 are illustrated in the simplified flow chart in FIG. 2B.

The battery state-of-health module 170 has submodule 171 adapted to obtain 1810 fleet vehicle battery degradation values BDV* for a plurality 230 of electric fleet vehicles having a vehicle type T1 corresponding to the particular electric vehicle 221. In other words, for each EV of the electric fleet 230 having the same vehicle type as EV 221, battery degradation values were determined in accordance with the method illustrated by FIG. 2A. A fleet parameter database 200fp stores respective fleet vehicle battery degradation values BDV* which are associated with odometer readings below a predefined threshold indicating a near-perfect state-of-health of the respective battery. In the example, also the battery degradation values BDVj, BDVk of EV 221 are added to the fleet parameter database for later use as long as the associated odometer readings for EV 221 are below said threshold. A typical threshold value is in the order of 2500 km. However, the threshold may vary dependent on the battery type used by the EV. In the example, the fleet parameter database 200fp includes battery degradation values BDF1 to BDF3 for three EVs - EV1 to EV3 - of the same vehicle type T1 as EV 221. Data of EVs of other vehicle types may also be stored in the same database (e.g., EV4|T2|BDV4).

SM 171 then aggregates (+) 1820 the obtained fleet vehicle battery degradation values BDV* belonging to respective seasonal time intervals SI1, SI2, SI3. Thereby, each seasonal time interval represents a corresponding seasonal period of the year. For the example of FIG. 1B, it is assumed that each seasonal time interval corresponds to a particular month of the year. That is, there are twelve seasonal time intervals (January to December). Of course, this implies that each battery degradation record in database 200fp comprises a field which matches one of the seasonal time intervals. The aggregation is illustrated by the (+) operator and is performed by determining a first measure of central tendency fleet degradation value BDF1, BDF2, BDF3 for each seasonal time interval SI1, SI2, SI3. In the example, all obtained battery degradation values (e.g., BDV1, BDV2, BDV3) which relate to the first seasonal time interval S1 are aggregated in that the median of such values is determined as the respective aggregated fleet battery degradation value BDF1 for the seasonal time interval S1. Similarly, aggregated fleet battery degradation values BDF2, BDF3 are determined for seasonal time intervals SI2, SI3, respectively, and so on.

SM 171 further computes 1840, for the plurality 230 of electric fleet vehicles, a second measure of central tendency fleet degradation value MCTBDF_AT1 for an assessment time interval AT1. The length of the assessment time interval AT1 is a multiple of the length of a seasonal time interval. In an advantageous implementation, the length of the assessment time interval AT1 corresponds to three months. In the example, AT1 has the length of SI1+SI2. The second measure of central tendency fleet degradation value MCTBDF_AT1 is based on the first measure of central tendency fleet degradation values (e.g., BDF1, BDF2) of the respective seasonal time intervals (SI1, SI2). In other words, if, for example, the first measure of central tendency fleet degradation values are the median values of the respective seasonal time intervals, then the second measure of central tendency fleet degradation value is the median value of said seasonal time interval median values which fall into the assessment time interval AT1. In case the number of seasonal time intervals is less than three, the mean value of said median values could be used instead.

Submodule SM 172 is adapted to compute 1830, for EV 221, a measure of central tendency battery degradation value MCTBDV_AT1 for the assessment time interval AT1. It is to be noted that the assessment time interval AT1 used by SM 172 is the same as for SM 171. In other words, for example, SM 172 may compute the median or mean value of the median/mean values from the EV specific battery degradation values obtained for the respective seasonal time intervals (e.g., SI1, SI2, ...) associated with AT1. The EV specific battery degradation values are received from BD 160 and not from the fleet parameter database 200fp. In an alternative implementation, a person skilled in the art can use odometer intervals instead of assessment time intervals for the SOH assessment.

Finally, submodule SM 173 is adapted to determine 1850 the relative distance, illustrated by the operator (-), between the measure of central tendency battery degradation value MCTBDV_AT1 and the second measure of central tendency fleet degradation value MCTBDF_AT1 as a state-of-health score SOHS-221 of the battery of the particular electric vehicle 221.

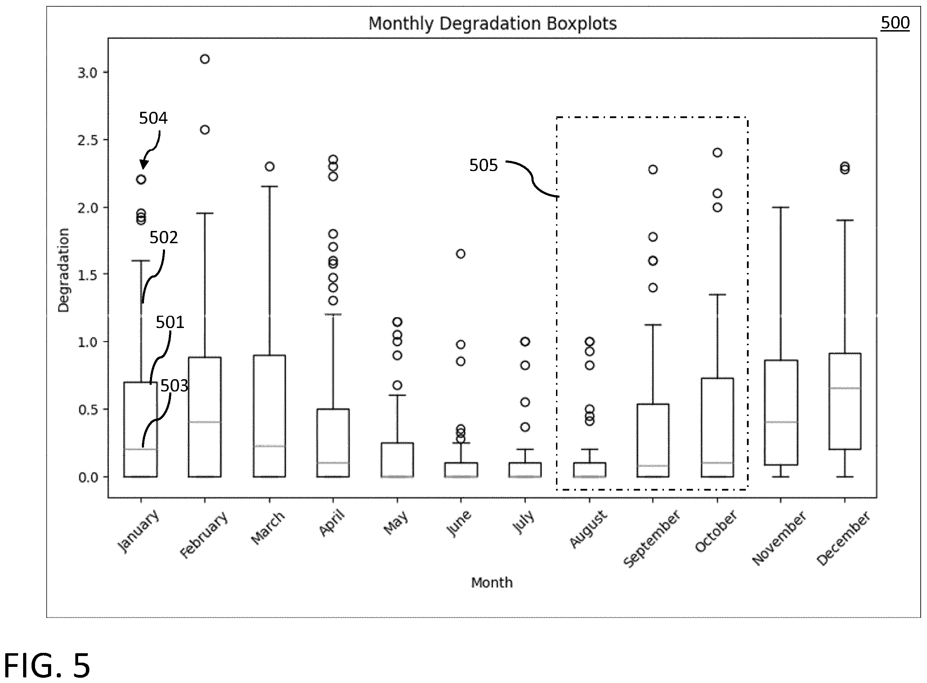

FIG. 5 shows a diagram 500 with monthly degradation boxplots for a fleet of EVs (of the same vehicle type) based on real charging parameters obtained from charging runs for said vehicles which were performed at odometer readings below a predefined threshold indicating a near-perfect health of the EVs' respective batteries. In the example, the threshold was set at 2500 km. The meaning of the monthly boxplots in diagram 500 is explained by way of example for the boxplot associated with the month of January. The box 501 represents the second and third quantile of the degradation values (from 0% to 0.7%) of all charging runs in January for said fleet of EVs. That is, box 501 represents the interquartile range (IQR) which includes 50% of the data points (25% to 75%). The horizontal bar 503 shows the position of the median (0.2%) of the January degradation values. This median corresponds to the first measure of central tendency fleet degradation value in the aggregating step. The whisker 502 is an extension of box 501 obtained by multiplying the IQR by a factor of 1.5. The single data points 504 (circles above the whisker 502) are considered to be outliers.

The degradation values for every EV in the fleet are determined in accordance with the herein disclosed computer-implemented method and stored in a respective database (e.g., fleet database 200fp in FIG. 1B). By using only data points where odometer readings are below 2500km, the system ensures that only batteries with "near-perfect health" are taken into account. The data points are then assigned to the months of the year where the respective charging runs occurred. Median or mean values are determined for each month can be stored in a respective database (e.g., 200fp). For determining the state-of-health score of the particular EV, the battery degradation is determined for said particular EV in accordance with the herein disclosed indirect measurement method. In the example, an assessment time interval 505 over three months (August to October) is used for comparing the particular vehicles' average battery degradation with the respective average fleet degradation value. The state-of-health score is the determined by calculating the relative distance between such values derived for the assessment time interval. In the example, the median fleet degradation values during the summer months were all 0% (i.e., the respective battery health was perfect). But even during the colder season of the year, the median fleet degradation values were below 1% which indicates a "near-perfect health" of the fleet vehicles also during those months. The median of the fleet degradation values in the assessment time interval 505 is 0.1%. Assuming that the median vehicle battery degradation in said interval is 0.15%, the SOH score results can be computed as:

$$score = ((100 - scaledVehicleSum) / (100 - scaledVariantSum)) * 100,$$

wherein scaledVehicleSum is the average degradation over the past x (e.g., 3) months for an individual EV, and scaledVariantSum is the average fleet degradation over the past x months. When using the example with the median vehicle battery degradation in said interval at 0.15%, the score is computed by: score = ((100 - 0.15) / (100 - 0.1)) * 100 = 99.95 SOH.

In case the mean values are used, the mean fleet degradation is obtained as: (0.0 + 0.1 + 0.1) / 3 = 0.067 resulting in a SOH score of 99.92.

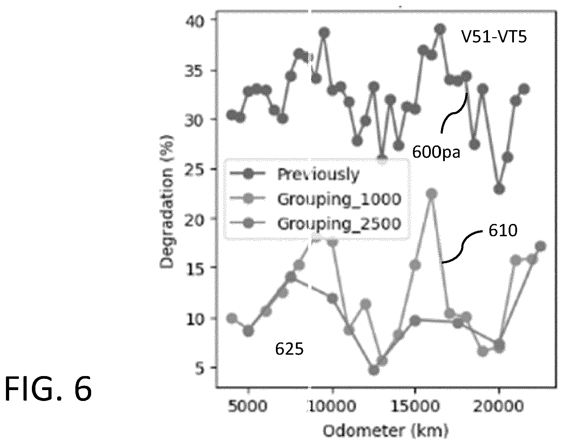

FIG. 6 illustrates a comparison between battery degradation of a vehicle V51-VT5 determined in accordance with a prior art approach (curve 600pa) and two implementations of the herein disclosed approach. In the prior art approach, battery degradation is determined based on all data points as the average of 1 - (vehicle range/maximum range). There is no advance grouping and not data cleaning. For the measured curve 610, grouping intervals with a size of 1000 km were used. For the measured curve 625, grouping intervals with a size of 2500 km were used. As in curve 625 the grouping intervals included more data points, the curve 625 is smoother than curve 610. However, both implementations show degradations which are significantly below the degradation values 600pa obtained by the prior art approach and which are significantly closer to the actual degradation values of the respective battery. The herein disclosed two-stage measure of central tendency approach - optionally in combination with applied data cleaning methods - leads to a more accurate indirect measurement of the battery degradation of an EV than the prior art approach.

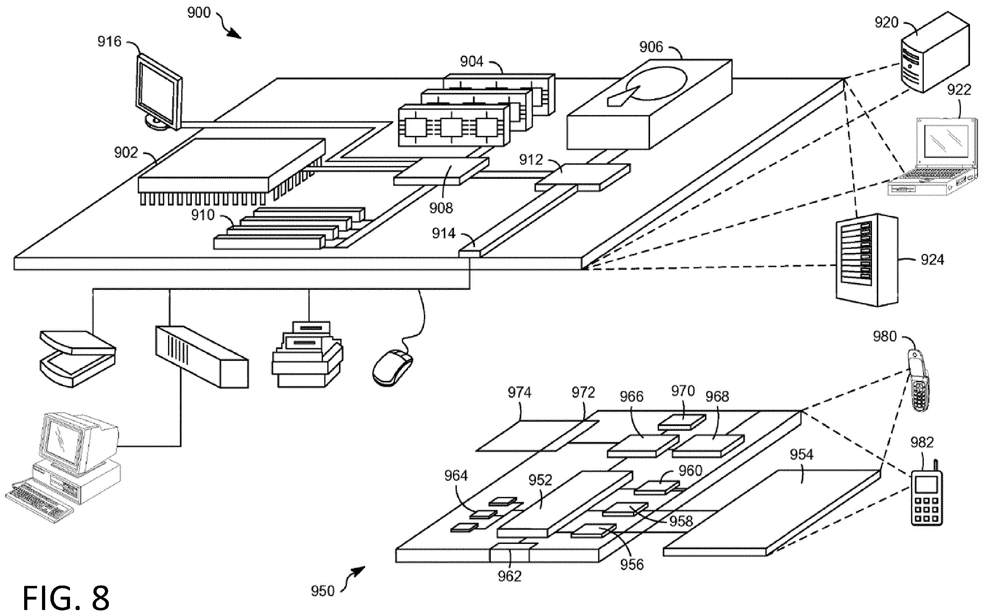

FIG. 8 is a diagram that shows an example of a generic computer device 900 and a generic mobile computer device 950, which may be used with the techniques described here. Computing device 900 is intended to represent various forms of digital computers, such as laptops, desktops, workstations, personal digital assistants, servers, blade servers, mainframes, and other appropriate computers. Generic computer device 900 may correspond to the computer system 100 of FIG. 1. Computing device 950 is intended to represent various forms of mobile devices, such as personal digital assistants, cellular telephones, smart phones, and other similar computing devices. For example, computing device 950 may be used as a frontend by a user to interact with the computing device 900. For example, device 950 may also provide the frontend to interact with the application. The components shown here, their connections and relationships, and their functions, are meant to be exemplary only, and are not meant to limit implementations of the inventions described and/or claimed in this document.

Computing device 900 includes a processor 902, memory 904, a storage device 906, a high-speed interface 908 connecting to memory 904 and high-speed expansion ports 910, and a low-speed interface 912 connecting to low speed bus 914 and storage device 906. Each of the components 902, 904, 906, 908, 910, and 912, are interconnected using various busses, and may be mounted on a common motherboard or in other manners as appropriate. The processor 902 can process instructions for execution within the computing device 900, including instructions stored in the memory 904 or on the storage device 906 to display graphical information for a GUI on an external input/output device, such as display 916 coupled to high-speed interface 908. In other implementations, multiple processors and/or multiple buses may be used, as appropriate, along with multiple memories and types of memory. Also, multiple computing devices 900 may be connected, with each device providing portions of the necessary operations (e.g., as a server bank, a group of blade servers, or a multi-processor system).

The memory 904 stores information within the computing device 900. In one implementation, the memory 904 is a volatile memory unit or units. In another implementation, the memory 904 is a non-volatile memory unit or units. The memory 904 may also be another form of computer-readable medium, such as a magnetic or optical disk.

The storage device 906 is capable of providing mass storage for the computing device 900. In one implementation, the storage device 906 may be or contain a computer-readable medium, such as a floppy disk device, a hard disk device, an optical disk device, or a tape device, a flash memory or other similar solid-state memory device, or an array of devices, including devices in a storage area network or other configurations. A computer program product can be tangibly embodied in an information carrier. The computer program product may also contain instructions that, when executed, perform one or more methods, such as those described above. The information carrier is a computer- or machine-readable medium, such as the memory 904, the storage device 906, or memory on processor 902.

The high-speed controller 908 manages bandwidth-intensive operations for the computing device 900, while the low-speed controller 912 manages lower bandwidth-intensive operations. Such allocation of functions is exemplary only. In one implementation, the high-speed controller 908 is coupled to memory 904, display 916 (e.g., through a graphics processor or accelerator), and to high-speed expansion ports 910, which may accept various expansion cards (not shown). In the implementation, low-speed controller 912 is coupled to storage device 906 and low-speed expansion port 914. The low-speed expansion port, which may include various communication ports (e.g., USB, Bluetooth, Ethernet, wireless Ethernet) may be coupled to one or more input/output devices, such as a keyboard, a pointing device, a scanner, or a networking device such as a switch or router, e.g., through a network adapter.

The computing device 900 may be implemented in a number of different forms, as shown in the figure. For example, it may be implemented as a standard server 920, or multiple times in a group of such servers. It may also be implemented as part of a rack server system 924. In addition, it may be implemented in a personal computer such as a laptop computer 922. Alternatively, components from computing device 900 may be combined with other components in a mobile device (not shown), such as device 950. Each of such devices may contain one or more of computing device 900, 950, and an entire system may be made up of multiple computing devices 900, 950 communicating with each other.

Computing device 950 includes a processor 952, memory 964, an input/output device such as a display 954, a communication interface 966, and a transceiver 968, among other components. The device 950 may also be provided with a storage device, such as a microdrive or other device, to provide additional storage. Each of the components 950, 952, 964, 954, 966, and 968, are interconnected using various buses, and several of the components may be mounted on a common motherboard or in other manners as appropriate.

The processor 952 can execute instructions within the computing device 950, including instructions stored in the memory 964. The processor may be implemented as a chipset of chips that include separate and multiple analog and digital processors. The processor may provide, for example, for coordination of the other components of the device 950, such as control of user interfaces, applications run by device 950, and wireless communication by device 950.

Processor 952 may communicate with a user through control interface 958 and display interface 956 coupled to a display 954. The display 954 may be, for example, a TFT LCD (Thin-Film-Transistor Liquid Crystal Display) or an OLED (Organic Light Emitting Diode) display, or other appropriate display technology. The display interface 956 may comprise appropriate circuitry for driving the display 954 to present graphical and other information to a user. The control interface 958 may receive commands from a user and convert them for submission to the processor 952. In addition, an external interface 962 may be provide in communication with processor 952, so as to enable near area communication of device 950 with other devices. External interface 962 may provide, for example, for wired communication in some implementations, or for wireless communication in other implementations, and multiple interfaces may also be used.

The memory 964 stores information within the computing device 950. The memory 964 can be implemented as one or more of a computer-readable medium or media, a volatile memory unit or units, or a non-volatile memory unit or units. Expansion memory 984 may also be provided and connected to device 950 through expansion interface 982, which may include, for example, a SIMM (Single In Line Memory Module) card interface. Such expansion memory 984 may provide extra storage space for device 950, or may also store applications or other information for device 950. Specifically, expansion memory 984 may include instructions to carry out or supplement the processes described above, and may include secure information also. Thus, for example, expansion memory 984 may act as a security module for device 950, and may be programmed with instructions that permit secure use of device 950. In addition, secure applications may be provided via the SIMM cards, along with additional information, such as placing the identifying information on the SIMM card in a non-hackable manner.

The memory may include, for example, flash memory and/or NVRAM memory, as discussed below. In one implementation, a computer program product is tangibly embodied in an information carrier. The computer program product contains instructions that, when executed, perform one or more methods, such as those described above. The information carrier is a computer- or machine-readable medium, such as the memory 964, expansion memory 984, or memory on processor 952 that may be received, for example, over transceiver 968 or external interface 962.

Device 950 may communicate wirelessly through communication interface 966, which may include digital signal processing circuitry where necessary. Communication interface 966 may provide for communications under various modes or protocols, such as GSM voice calls, SMS, EMS, or MMS messaging, CDMA, TDMA, PDC, WCDMA, CDMA2000, or GPRS, among others. Such communication may occur, for example, through radio-frequency transceiver 968. In addition, short-range communication may occur, such as using a Bluetooth, WiFi, or other such transceiver (not shown). In addition, GPS (Global Positioning System) receiver module 980 may provide additional navigation- and location-related wireless data to device 950, which may be used as appropriate by applications running on device 950.

Device 950 may also communicate audibly using audio codec 960, which may receive spoken information from a user and convert it to usable digital information. Audio codec 960 may likewise generate audible sound for a user, such as through a speaker, e.g., in a handset of device 950. Such sound may include sound from voice telephone calls, may include recorded sound (e.g., voice messages, music files, etc.) and may also include sound generated by applications operating on device 950.

The computing device 950 may be implemented in a number of different forms, as shown in the figure. For example, it may be implemented as a cellular telephone 980. It may also be implemented as part of a smart phone 982, personal digital assistant, or another similar mobile device.

Various implementations of the systems and techniques described here can be realized in digital electronic circuitry, integrated circuitry, specially designed ASICs (application specific integrated circuits), computer hardware, firmware, software, and/or combinations thereof. These various implementations can include implementation in one or more computer programs that are executable and/or interpretable on a programmable system including at least one programmable processor, which may be special or general purpose, coupled to receive data and instructions from, and to transmit data and instructions to, a storage system, at least one input device, and at least one output device.

These computer programs (also known as programs, software, software applications or code) include machine instructions for a programmable processor, and can be implemented in a high-level procedural and/or object-oriented programming language, and/or in assembly/machine language. As used herein, the terms "machine-readable medium" and "computer-readable medium" refer to any computer program product, apparatus and/or device (e.g., magnetic discs, optical disks, memory, Programmable Logic Devices (PLDs)) used to provide machine instructions and/or data to a programmable processor, including a machine-readable medium that receives machine instructions as a machine-readable signal. The term "machine-readable signal" refers to any signal used to provide machine instructions and/or data to a programmable processor.

To provide for interaction with a user, the systems and techniques described here can be implemented on a computer having a display device (e.g., a CRT (cathode ray tube) or LCD (liquid crystal display) monitor) for displaying information to the user and a keyboard and a pointing device (e.g., a mouse or a trackball) by which the user can provide input to the computer. Other kinds of devices can be used to provide for interaction with a user as well; for example, feedback provided to the user can be any form of sensory feedback (e.g., visual feedback, auditory feedback, or tactile feedback); and input from the user can be received in any form, including acoustic, speech, or tactile input.

The systems and techniques described here can be implemented in a computing device that includes a back end component (e.g., as a data server), or that includes a middleware component (e.g., an application server), or that includes a front end component (e.g., a client computer having a graphical user interface or a Web browser through which a user can interact with an implementation of the systems and techniques described here), or any combination of such back end, middleware, or front end components. The components of the system can be interconnected by any form or medium of digital data communication (e.g., a communication network). Examples of communication networks include a local area network ("LAN"), a wide area network ("WAN"), and the Internet.

The computing device can include clients and servers. A client and server are generally remote from each other and typically interact through a communication network. The relationship of client and server arises by virtue of computer programs running on the respective computers and having a client-server relationship to each other.

## Claims

1.  A computer-implemented method (1000) for indirect measurement of battery degradation of a particular electric vehicle (221), comprising:

    receiving (1100) a plurality of parameter sets (200p) associated with a plurality (200) of completed charging runs (CR1 to CRn) of the vehicle, wherein each charging run is associated with one or more parameter sets, wherein a particular parameter set associated with a particular charging run (CR*) comprises: a charging level of the battery (220b-*), a corresponding vehicle range related parameter value (220r-*), and at least one of a corresponding odometer reading (220o-*) of the vehicle or a corresponding time point (220t-*), associated with the particular charging run (CR*);
    grouping (1200), within grouping intervals (GI*), the vehicle range related parameter values (220r-*) by corresponding charging levels (220b-*) belonging to a corresponding grouping interval, wherein, in a first alternative, the grouping intervals (GI*) are predefined odometer reading intervals in which the respective charging runs occurred, or, in a second alternative, the grouping intervals are predefined time intervals in which the respective charging runs occurred;
    determining (1300) for each of the plurality (200) of completed charging runs, a maximum value (220mr-*) of the vehicle range related parameter obtained for associated charging levels across all grouping intervals (GI*);
    computing (1400), for each charging level, a first measure of central tendency (200rct-*) of the associated vehicle range related parameter values in each grouping interval;
    computing (1500), for each associated charging level (220b-*) in each grouping interval (GI*), the ratio of the respective computed first measure of central tendency to the respective maximum value of vehicle range related parameter values, and determining (1600) an intermediate battery degradation value by grouping interval for each charging level based on said ratios; and
    computing (1700), for each grouping interval, a second measure of central tendency of all intermediate battery degradation values across all charging levels in the respective grouping interval (GI*) resulting in the battery degradation values (BDV*) for each grouping interval.

2. The method of claim 1, further comprising:
prior to grouping, removing outlier and/or data of bad quality from the received parameter values by applying (1150) a data cleaning method.

3. The method of claim 2, wherein the data cleaning involves identifying or flagging data for cleaning using one or more of the following methods: distance metrics comprising Mahalanobis Distance and Z-Score for outlier detection, estimation methods comprising Minimum Covariance Determinant estimator for determining multivariate outliers, and algorithms comprising Local Outlier Factor for multivariate outlier detection and clustering algorithms comprising DBSCAN and k-Means for group-based outlier detection.

4. The method of any of the previous claims, wherein the vehicle range related parameter value is one of: a vehicle range value provided by the vehicle, a number of kWh being charged for achieving said range related parameter value, or voltage and amperage and time used for the charging run to charge said number of kWh.

5. The method of any of the previous claims, further comprising:

obtaining (1810) fleet vehicle battery degradation values for a plurality of electric fleet vehicles having a vehicle type corresponding to the particular electric vehicle, wherein the obtained fleet vehicle battery degradation values are associated with odometer readings below a predefined threshold indicating a near-perfect state-of-health of the respective battery;
aggregating (1820) obtained fleet vehicle battery degradation values belonging to respective seasonal time intervals wherein each seasonal time interval represents a corresponding seasonal period of the year by determining a first measure of central tendency fleet degradation value for each seasonal time interval;
computing (1830), for the particular vehicle, a measure of central tendency battery degradation value for an assessment time interval (AT1) having a length which is a multiple of the length of a seasonal time interval;
computing (1840), for the plurality of electric fleet vehicles, a second measure of central tendency fleet degradation value for the assessment time interval, wherein the second measure of central tendency fleet degradation value is based on the first measure of central tendency fleet degradation values of the respective seasonal time intervals; and
determining (1850) the relative distance between the measure of central tendency battery degradation value and the second measure of central tendency fleet degradation value as a state-of-health score of the battery of the particular electric vehicle.

6. The method of claim 5, wherein the seasonal time intervals are: the weeks of the year or groups of consecutive weeks, the months of the year, or time intervals representing the seasons of the year.

7. The method of any of the previous claims, wherein measures of central tendency are selected from: mean, median and mode.

8. A computer program product for indirect measurement of battery degradation of a particular electric vehicle, that when loaded into a memory of a computing device and executed by at least one processor of the computing device executes the steps of the computer-implemented method according to any of the previous claims.

9. A computer system (100) for indirect measurement of battery degradation of a particular electric vehicle (221), the system comprising:

an interface configured to receive a plurality of parameter sets (200p) associated with a plurality (200) of completed charging runs (CR1 to CRn) of the vehicle, wherein each charging run is associated with one or more parameter sets, wherein a particular parameter set associated with a particular charging run (CR*) comprises: a charging level of the battery (220b-*), a corresponding vehicle range related parameter value (220r-*), and at least one of a corresponding odometer reading (220o-*) of the vehicle or a corresponding time point (220t-*), associated with the particular charging run (CR*);
a grouping module (120) adapted to group, within grouping intervals (GI*), the vehicle range related parameter values (220r-*) by corresponding charging levels (220b-*) belonging to a corresponding grouping interval, wherein, in a first alternative, the grouping intervals (GI*) are predefined odometer reading intervals in which the respective charging runs occurred, or, in a second alternative, the grouping intervals are predefined time intervals in which the respective charging runs occurred;
a maximum range module (130) adapted to determine for each of the plurality (200) of completed charging runs, a maximum value (220mr-*) of the vehicle range related parameter obtained for associated charging levels across all grouping intervals (GI*);

a measure of central tendency module (140) adapted to compute, for each charging level, a first measure of central tendency (200rct-*) of the associated vehicle range related parameter values in each grouping interval;

an intermediate battery degradation module (150) adapted to compute, for each associated charging level (220b-*) in each grouping interval (GI*), the ratio of the respective computed first measure of central tendency to the respective maximum value of vehicle range related parameter values, and to determine an intermediate battery degradation value by grouping interval for each charging level based on said ratios; and

a battery degradation module (160) adapted to compute, for each grouping interval, a second measure of central tendency of all intermediate battery degradation values across all charging levels in the respective grouping interval (GI*) resulting in the battery degradation values (BDV*) for each grouping interval.

10. The system of claim 9, further comprising:
a data cleaning module (110) adapted to remove outlier and/or data of bad quality from the received parameter values by applying a data cleaning method before providing cleaned data to the grouping module (120).

11. The system of any of claim 9 or 10, further comprising a battery state-of-health module (170) adapted to:

obtain fleet vehicle battery degradation values (BDV*) for a plurality (230) of electric fleet vehicles having a vehicle type (T1) corresponding to the particular electric vehicle (221), wherein the obtained fleet vehicle battery degradation (BDV*) values are associated with odometer readings below a predefined threshold indicating a near-perfect state-of-health of the respective battery;

aggregate (+) obtained fleet vehicle battery degradation values (BDV*) belonging to respective seasonal time intervals (SI1, SI2, SI3), wherein each seasonal time interval represents a corresponding seasonal period of the year, by determining a first measure of central tendency fleet degradation value (BDF1, BDF2, BDF3) for each seasonal time interval (SI1, SI2, SI3);

compute, for the particular vehicle (221), a measure of central tendency battery degradation value (MCTBDV_AT1) for an assessment time interval (AT1) having a length which is a multiple of the length of a seasonal time interval;

compute, for the plurality (230) of electric fleet vehicles, a second measure of central tendency fleet degradation value (MCTBDF_AT1) for the assessment time interval (AT1), wherein the second measure of central tendency fleet degradation value is based on the first measure of central tendency fleet degradation values (BDF1, BDF2) of the respective seasonal time intervals (SI1, SI2); and

determine the relative distance (-) between the measure of central tendency battery degradation value (MCTBDV_AT1) and the second measure of central tendency fleet degradation value (MCTBDF_AT1) as a state-of-health score (SOHS-221) of the battery of the particular electric vehicle (221).

12. The system of any of the claims 9 to 11, wherein measures of central tendency are selected from: mean, median and mode.

13. The system of claim 10, wherein the data cleaning is adapted to identify or flag data for cleaning using one or more of the following methods: distance metrics comprising Mahalanobis Distance and Z-Score for outlier detection, estimation methods comprising Minimum Covariance Determinant estimator for determining multivariate outliers, and algorithms comprising Local Outlier Factor for multivariate outlier detection and clustering algorithms comprising DBSCAN and k-Means for group-based outlier detection.

14. The system of any of the claims 9 to 13, wherein the vehicle range related parameter value is one of: a vehicle range value provided by the vehicle, a number of kWh being charged for achieving said range related parameter value, or voltage and amperage and time used for the charging run to charge said number of kWh.

**Patentansprüche**

1. Ein computerimplementiertes Verfahren (1000) zur indirekten Messung der Batterieverschlechterung eines bestimmten Elektrofahrzeugs (221), umfassend:

Empfangen (1100) einer Vielzahl von Parametersätzen (200p), die einer Vielzahl (200) von abgeschlossenen Ladevorgängen (CR1 bis CRn) des Fahrzeugs zugeordnet sind, wobei jeder Ladevorgang einem oder mehreren Parametersätzen zugeordnet ist, wobei ein bestimmter Parametersatz, der einem bestimmten Ladevorgang (CR*) zugeordnet ist, umfasst: einen Ladezustand der Batterie (220b-*), einen entsprechenden, die Reichweite des Fahrzeugs betreffenden Parameterwert (220r-*) und mindestens einen der folgenden Werte: einen entsprechenden Kilometerstand (220o-*) des Fahrzeugs oder einen entsprechenden Zeitpunkt (220t-*), der dem bestimmten Ladevorgang (CR*) zugeordnet ist;

Innerhalb von Gruppierungsintervallen (GI*), Gruppieren (1200) der fahrzeugreichweitenbezogenen Parameterwerte (220r-*) nach entsprechenden Ladezuständen (220b-*), die zu einem entsprechenden Gruppierungsintervall gehören, wobei in einer ersten Alternative die Gruppierungsintervalle (GI*) vordefinierte Kilometerstandintervalle sind, in denen die jeweiligen Ladevorgänge stattfanden, oder in einer zweiten Alternative die Gruppierungsintervalle vordefinierte Zeitintervalle sind, in denen die jeweiligen Ladevorgänge stattfanden;

Ermitteln (1300) für jeden der Vielzahl (200) abgeschlossener Ladevorgänge eines Maximalwerts (220mr-*) des fahrzeugreichweitenbezogenen Parameters, der für zugehörige Ladezustände über alle Gruppierungsintervalle (GI*) hinweg ermittelt wurde;

Berechnen (1400) für jeden Ladezustand eines ersten Maßes der zentralen Tendenz (200rct-*) der zugehörigen Werte des Fahrzeugreichweiten-bezogenen Parameters in jedem Gruppierungsintervall;

Für jeden zugehörigen Ladezustand (220b-*) in jedem Gruppierungsintervall (GI*), Berechnen (1500) des Verhältnisses des jeweiligen berechneten ersten Maßes der Zentralität zum jeweiligen Maximalwert der Werte des Fahrzeugreichweiten-bezogenen Parameters und Bestimmen (1600) eines Zwischenwerts für die Batterieverschlechterung pro Gruppierungsintervall für jeden Ladezustand auf der Grundlage der genannten Verhältnisse; und

Für jedes Gruppierungsintervall, Berechnen (1700), eines zweiten Maßes der zentralen Tendenz aller Zwischenwerte für die Werte der Batterieverschlechterung über alle Ladestufen im jeweiligen Gruppierungsintervall (GI*), resultierend in den Werten der Batterieverschlechterung (BDV*) für jedes Gruppierungsintervall.

2. Verfahren nach Anspruch 1, ferner umfassend:
vor dem Gruppieren, Entfernen von Ausreißern und/oder Daten schlechter Qualität aus den empfangenen Parameterwerten durch Anwenden (1150) eines Datenbereinigungsverfahrens.

3. Das Verfahren nach Anspruch 2, wobei die Datenbereinigung das Identifizieren oder Markieren von Daten zur Bereinigung unter Verwendung einer oder mehrerer der folgenden Methoden umfasst: Distanzmetriken, einschließlich Mahalanobis-Distanz und Z-Score zur Ausreißererkennung, Schätzverfahren, einschließlich des Schätzers der minimalen Kovarianzdeterminante zur Bestimmung multivariater Ausreißer, sowie Algorithmen, einschließlich des Local Outlier Factor zur multivariaten Ausreißererkennung, und Clustering-Algorithmen, einschließlich DBSCAN und k-Means zur gruppenbasierten Ausreißererkennung.

4. Verfahren nach einem der vorstehenden Ansprüche, wobei der auf die Fahrzeugreichweite bezogene Parameterwert einer der folgenden ist: ein vom Fahrzeug bereitgestellter Fahrzeugreichweitenwert, eine Anzahl von kWh, die geladen werden, um den genannten auf die Reichweite bezogenen Parameterwert zu erreichen, oder Spannung und Stromstärke und die für den Ladevorgang zur Ladung der genannten Anzahl von kWh aufgewendete Zeit.

5. Verfahren nach einem der vorstehenden Ansprüche, das ferner umfasst:

Ermitteln (1810) von Werten der Batterieverschlechterung von Flottenfahrzeugen für eine Vielzahl von Elektro-Flottenfahrzeugen mit einem Fahrzeugtyp, der dem bestimmten Elektrofahrzeug entspricht, wobei die ermittelten Werte der Batterieverschlechterung von Flottenfahrzeugen mit Kilometerständen unterhalb eines vordefinierten Schwellenwerts assoziiert sind, der einen nahezu perfekten Gesundheitszustand der jeweiligen Batterie kennzeichnet;

Aggregieren (1820) der ermittelten Werte für die Batterieverschlechterung der Flottenfahrzeuge, die zu jeweiligen saisonalen Zeitintervallen gehören, wobei jedes saisonale Zeitintervall einen entsprechenden Jahreszeitraum darstellt, durch Bestimmen eines ersten Maßes für die zentrale Tendenz der Batterieverschlechterung der Flotte für jedes saisonale Zeitintervall;

Berechnen (1830) eines Maßes der zentralen Tendenz der Batterieverschlechterung für das jeweilige Fahrzeug für ein Bewertungszeitintervall (AT1), dessen Länge ein Vielfaches der Länge eines saisonalen Zeitintervalls ist;

Berechnen (1840) eines zweiten Maßes für die zentrale Tendenz des Flottenverschlechterung für das Bewertungszeitintervall für die Vielzahl von Elektrofahrzeugen der Flotte, wobei das zweite Maß für die zentrale Tendenz des Flottenverschlechterung auf dem ersten Maß für die zentrale Tendenz der Flottenverschlechterung der jeweiligen saisonalen Zeitintervalle basiert; und

Bestimmen (1850) des relativen Abstands zwischen dem Maß für die zentrale Tendenz der Batterieverschlechterung und dem zweiten Maß für die zentrale Tendenz des Flottenverschlechterungswerts als Zustandsbewertung der Batterie des bestimmten Elektrofahrzeugs.

6. Verfahren nach Anspruch 5, wobei die saisonalen Zeitintervalle sind: die Wochen des Jahres oder Gruppen aufeinanderfolgender Wochen, die Monate des Jahres oder Zeitintervalle, die die Jahreszeiten darstellen.

7. Verfahren nach einem der vorstehenden Ansprüche, wobei die Maße der zentralen Tendenz aus Mittelwert, Median und Modus ausgewählt werden.

8. Ein Computerprogrammprodukt zur indirekten Messung der Batterieverschlechterung eines bestimmten Elektrofahrzeugs, das, wenn es in einen Speicher einer Recheneinrichtung geladen und von mindestens einem Prozessor der Recheneinrichtung ausgeführt wird, die Schritte des computerimplementierten Verfahrens gemäß einem der vorstehenden Ansprüche ausführt.

9. Ein Computersystem (100) zur indirekten Messung der Batterieverschlechterung eines bestimmten Elektrofahrzeugs (221), wobei das System umfasst:

eine Schnittstelle, die so konfiguriert ist, dass sie eine Vielzahl von Parametersätzen (200p) empfängt, die einer Vielzahl (200) von abgeschlossenen Ladevorgängen (CR1 bis CRn) des Fahrzeugs zugeordnet sind, wobei jeder Ladevorgang einem oder mehreren Parametersätzen zugeordnet ist, wobei ein bestimmter Parametersatz, der einem bestimmten Ladevorgang (CR*) zugeordnet ist, umfasst: einen Ladezustand der Batterie (220b-*), einen entsprechenden, die Reichweite des Fahrzeugs betreffenden Parameterwert (220r-*) und mindestens einen der folgenden Werte: einen entsprechenden Kilometerstand (220o-*) des Fahrzeugs oder einen entsprechenden Zeitpunkt (220t-*), der dem bestimmten Ladevorgang (CR*) zugeordnet ist;
ein Gruppierungsmodul (120), das dazu ausgelegt ist, innerhalb von Gruppierungsintervallen (GI*) die fahrzeugreichweitenbezogenen Parameterwerte (220r-*) nach entsprechenden Ladezuständen (220b-*) zu gruppieren, die zu einem entsprechenden Gruppierungsintervall gehören, wobei in einer ersten Ausführungsform die Gruppierungsintervalle (GI*) vordefinierte Kilometerstandintervalle sind, in denen die jeweiligen Ladevorgänge stattfanden, oder in einer zweiten Ausführungsform die Gruppierungsintervalle vordefinierte Zeitintervalle sind, in denen die jeweiligen Ladevorgänge stattfanden;
ein Modul (130) zur Ermittlung der maximalen Reichweite, das dazu ausgelegt ist, für jeden der Vielzahl (200) abgeschlossener Ladevorgänge einen Maximalwert (220mr-*) des fahrzeugreichweitenbezogenen Parameters zu ermitteln, der für zugehörige Ladezustände über alle Gruppierungsintervalle (GI*) hinweg erhalten wurde;
ein Modul zur Berechnung von zentralen Tendenzen (140), das dazu ausgelegt ist, für jeden Ladezustand ein erstes Maß (200rct-*) für eine zentrale Tendenz der zugehörigen Werte des fahrzeugreichweitenbezogenen Parameters in jedem Gruppierungsintervall zu berechnen;
ein Modul zur Berechnung der Werte einer Zwischenbatterieverschlechterung (150), das dazu ausgelegt ist, für jeden zugehörigen Ladezustand (220b-*) in jedem Gruppierungsintervall (GI*) das Verhältnis des jeweiligen berechneten ersten Maßes der zentralen Tendenz zum jeweiligen Maximalwert der Werte des Fahrzeugreichweitenparameters zu berechnen und auf der Grundlage dieser Verhältnisse einen Wert der Batterieverschlechterung pro Gruppierungsintervall für jeden Ladezustand zu bestimmen; und
ein Modul zur Berechnung der Batterieverschlechterung (160), das dafür ausgelegt ist, für jedes Gruppierungsintervall ein zweites Maß der zentralen Tendenz aller Zwischenwerte der Batterieverschlechterung über alle Ladezustände im jeweiligen Gruppierungsintervall (GI*) zu berechnen, was in den Werten der Batterieverschlechterung (BDV*) für jedes Gruppierungsintervall resultiert.

10. Das System nach Anspruch 9, ferner umfassend:
ein Datenbereinigungsmodul (110), das dazu ausgelegt ist, Ausreißer und/oder Daten schlechter Qualität aus den empfangenen Parameterwerten zu entfernen, indem ein Datenbereinigungsverfahren angewendet wird, bevor bereinigte Daten an das Gruppierungsmodul (120) bereitgestellt werden.

11. Das System nach Anspruch 9 oder 10, ferner umfassend ein Batteriezustandsmodul (170), das dazu ausgelegt ist:

Ermitteln von Werten der Batterieverschlechterung (BDV*) für eine Vielzahl (230) von Elektrofahrzeugen der Flotte, die einen Fahrzeugtyp (T1) aufweisen, der dem bestimmten Elektrofahrzeug (221) entspricht, wobei die ermittelten Werte der Batterieverschlechterung (BDV*) mit Kilometerständen unterhalb eines vordefinierten Schwellenwerts assoziiert sind, der einen nahezu perfekten Zustand der jeweiligen Batterie kennzeichnet;
die ermittelten Werte der Batterieverschlechterung (BDV*) der Flottenfahrzeuge, die zu jeweiligen saisonalen Zeitintervallen (S11, SI2, SI3) gehören, zu aggregieren (+), wobei jedes saisonale Zeitintervall einen entsprechenden saisonalen Zeitraum des Jahres darstellt, indem für jedes saisonale Zeitintervall (SI1, SI2, SI3) ein erstes Maß für die zentrale Tendenz der Flotten-Batterieverschlechterung (BDF1, BDF2, BDF3) bestimmt wird;

Berechnen eines Maßes der zentralen Tendenz der Batterieverschlechterung (MCTBDV_AT1) für das bestimmte Fahrzeug (221) für ein Bewertungszeitintervall (AT1), dessen Länge ein Vielfaches der Länge eines saisonalen Zeitintervalls ist;

Berechnen eines zweiten Maßes für den zentralen Tendenzwert der Flottenverschlechterungswerte (MCTBDF_AT1) für die Vielzahl (230) von Elektrofahrzeugen der Flotte für das Bewertungszeitintervall (AT1), wobei das zweite Maß für den zentralen Tendenzwert der Flottenverschlechterungswerte auf den ersten Maßen für die zentralen Tendenzwerte der Flottenverschlechterungswerte (BDF1, BDF2) der jeweiligen saisonalen Zeitintervalle (SI1, SI2) basiert; und

Bestimmen des relativen Abstands (-) zwischen dem Maß der zentralen Tendenz der Batterieverschlechterung (MCTBDV_AT1) und dem zweiten Maß der zentralen Tendenz der Flottenverschlechterung (MCTBDF_AT1) als Zustandsbewertung (SOHS-221) der Batterie des bestimmten Elektrofahrzeugs (221).

12. Das System nach einem der Ansprüche 9 bis 11, wobei die Maße der zentralen Tendenz aus folgenden ausgewählt werden: Mittelwert, Median und Modus.

13. Das System nach Anspruch 10, wobei die Datenbereinigung so ausgelegt ist, dass sie Daten zur Bereinigung unter Verwendung einer oder mehrerer der folgenden Methoden identifiziert oder kennzeichnet: Distanzmetriken, die den Mahalanobis-Abstand und den Z-Score zur Erkennung von Ausreißern umfassen, Schätzverfahren, die den Schätzer der minimalen Kovarianzdeterminante zur Bestimmung multivariater Ausreißer umfassen, sowie Algorithmen, die den Local Outlier Factor zur Erkennung multivariater Ausreißer umfassen, und Clustering-Algorithmen, die DBSCAN und k-Means zur gruppenbasierten Erkennung von Ausreißern umfassen.

14. Das System nach einem der Ansprüche 9 bis 13, wobei der auf die Fahrzeugreichweite bezogene Parameterwert einer der folgenden ist: ein vom Fahrzeug bereitgestellter Fahrzeugreichweitenwert, eine Anzahl von kWh, die geladen werden, um den genannten auf die Reichweite bezogenen Parameterwert zu erreichen, oder Spannung und Stromstärke und die für den Ladevorgang zur Ladung der genannten Anzahl von kWh aufgewendete Zeit.

## Revendications

1. Procédé mis en œuvre par ordinateur (1000) pour la mesure indirecte de la dégradation de la batterie d'un véhicule électrique donné (221), comprenant :

la réception (1100) d'une pluralité d'ensembles de paramètres (200p) associés à une pluralité (200) de cycles de charge terminés (CR1 à CRn) du véhicule, dans laquelle chaque cycle de charge est associé à un ou plusieurs ensembles de paramètres, dans laquelle un ensemble de paramètres particulier associé à un cycle de charge particulier (CR*) comprend : un niveau de charge de la batterie (220b-*), une valeur de paramètre correspondante liée à l'autonomie du véhicule (220r-*), et au moins l'un parmi un relevé de compteur kilométrique correspondant (220o-*) du véhicule ou un instant correspondant (220t-*), associé au cycle de charge particulier (CR*) ;

le regroupement (1200), au sein d'intervalles de regroupement (GI*), les valeurs de paramètres liées à l'autonomie du véhicule (220r-*) par niveaux de charge correspondants (220b-*) appartenant à un intervalle de regroupement correspondant, dans lequel, dans une première variante, les intervalles de regroupement (GI*) sont des intervalles de kilométrage prédéfinis au cours desquels les cycles de charge respectifs ont eu lieu, ou, dans une deuxième variante, les intervalles de regroupement sont des intervalles de temps prédéfinis au cours desquels les cycles de charge respectifs ont eu lieu ;

déterminer (1300), pour chacun des cycles de recharge terminés (200), une valeur maximale (220mr-*) du paramètre lié à l'autonomie du véhicule obtenue pour les niveaux de charge associés sur l'ensemble des intervalles de regroupement (GI*) ;

calculer (1400), pour chaque niveau de charge, une première mesure de tendance centrale (200rct-*) des valeurs associées du paramètre lié à l'autonomie du véhicule dans chaque intervalle de regroupement ;

calculer (1500), pour chaque niveau de charge associé (220b-*) dans chaque intervalle de regroupement (GI*), le rapport entre la première mesure de tendance centrale calculée respective et la valeur maximale respective des valeurs du paramètre lié à l'autonomie du véhicule, et déterminer (1600) une valeur intermédiaire de dégradation de la batterie par intervalle de regroupement pour chaque niveau de charge sur la base desdits rapports ; et

calculer (1700), pour chaque intervalle de regroupement, une deuxième mesure de tendance centrale de toutes les valeurs intermédiaires de dégradation de la batterie sur l'ensemble des niveaux de charge dans l'intervalle de regroupement respectif (GI*), ce qui donne les valeurs de dégradation de la batterie (BDV*) pour chaque intervalle de regroupement.

2. Procédé selon la revendication 1, comprenant en outre :
avant le regroupement, la suppression des valeurs aberrantes et/ou des données de mauvaise qualité des valeurs de paramètres reçues en appliquant (1150) une méthode de nettoyage des données.

3. Procédé selon la revendication 2, dans lequel le nettoyage des données implique l'identification ou le marquage des données à nettoyer à l'aide d'une ou plusieurs des méthodes suivantes : des mesures de distance comprenant la distance de Mahalanobis et le score Z pour la détection des valeurs aberrantes, des méthodes d'estimation comprenant l'estimateur du déterminant de covariance minimale pour déterminer les valeurs aberrantes multivariées, et des algorithmes comprenant le facteur d'aberration local pour la détection des valeurs aberrantes multivariées et des algorithmes de regroupement comprenant DBSCAN et k-Means pour la détection des valeurs aberrantes par groupes.

4. Procédé selon l'une quelconque des revendications précédentes, dans lequel la valeur du paramètre lié à l'autonomie du véhicule est l'une des suivantes : une valeur d'autonomie fournie par le véhicule, un nombre de kWh en cours de charge pour atteindre ladite valeur du paramètre lié à l'autonomie, ou la tension, l'intensité du courant ainsi que le temps nécessaire au processus de charge pour charger ledit nombre de kWh.

5. Procédé selon l'une quelconque des revendications précédentes, comprenant en outre :

l'obtention (1810) de valeurs de dégradation de batterie de véhicules de flotte pour une pluralité de véhicules électriques de flotte ayant un type de véhicule correspondant au véhicule électrique particulier, dans lequel les valeurs de dégradation de batterie de véhicules de flotte obtenues sont associées à des relevés de compteur kilométrique inférieurs à un seuil prédéfini indiquant un état de santé quasi parfait de la batterie respective ;
agréger (1820) les valeurs de dégradation des batteries de véhicules de flotte obtenues appartenant à des intervalles de temps saisonniers respectifs, chaque intervalle de temps saisonnier représentant une période saisonnière correspondante de l'année, en déterminant une première mesure de tendance centrale de la valeur de dégradation de la flotte pour chaque intervalle de temps saisonnier ;
calculer (1830), pour le véhicule particulier, une mesure de tendance centrale de la valeur de dégradation de la batterie pour un intervalle de temps d'évaluation (AT1) ayant une durée qui est un multiple de la durée d'un intervalle de temps saisonnier ;
calculer (1840), pour la pluralité de véhicules électriques de la flotte, une deuxième mesure de tendance centrale de la valeur de dégradation de la flotte pour l'intervalle de temps d'évaluation, la deuxième mesure de tendance centrale de la valeur de dégradation de la flotte étant basée sur la première mesure de tendance centrale des valeurs de dégradation de la flotte des intervalles de temps saisonniers respectifs ; et
déterminer (1850) la distance relative entre la mesure de tendance centrale de la valeur de dégradation de la batterie et la deuxième mesure de tendance centrale de la valeur de dégradation de la flotte comme un score d'état de santé de la batterie du véhicule électrique particulier.

6. Procédé selon la revendication 5, dans lequel les intervalles de temps saisonniers sont : les semaines de l'année ou des groupes de semaines consécutives, les mois de l'année, ou des intervalles de temps représentant les saisons de l'année.

7. Procédé selon l'une quelconque des revendications précédentes, dans lequel les mesures de tendance centrale sont choisies parmi : la moyenne, la médiane et le mode.

8. Produit logiciel destiné à la mesure indirecte de la dégradation de la batterie d'un véhicule électrique particulier, qui, lorsqu'il est chargé dans une mémoire d'un dispositif informatique et exécuté par au moins un processeur dudit dispositif, exécute les étapes du procédé mis en œuvre par ordinateur selon l'une quelconque des revendications précédentes.

9. Système informatique (100) destiné à la mesure indirecte de la dégradation de la batterie d'un véhicule électrique particulier (221), le système comprenant :

une interface configurée pour recevoir une pluralité d'ensembles de paramètres (200p) associés à une pluralité (200) de cycles de charge terminés (CR1 à CRn) du véhicule, dans lequel chaque cycle de charge est associé à un ou plusieurs ensembles de paramètres, dans lequel un ensemble de paramètres particulier associé à un cycle de charge particulier (CR*) comprend : un niveau de charge de la batterie (220b-*), une valeur de paramètre correspondante liée à l'autonomie du véhicule (220r-*), et au moins l'un parmi un relevé de compteur kilométrique correspondant (220o-*) du véhicule ou un moment correspondant (220t-*), associé au cycle de charge particulier (CR*) ;

un module de regroupement (120) adapté pour regrouper, au sein d'intervalles de regroupement (GI*), les valeurs de paramètres liés à l'autonomie du véhicule (220r-*) par niveaux de charge correspondants (220b-*) appartenant à un intervalle de regroupement correspondant, dans lequel, dans une première variante, les intervalles de regroupement (GI*) sont des intervalles de kilométrage prédéfinis au cours desquels les cycles de charge respectifs ont eu lieu, ou, dans une deuxième variante, les intervalles de regroupement sont des intervalles de temps prédéfinis au cours desquels les cycles de charge respectifs ont eu lieu ;

un module d'autonomie maximale (130) adapté pour déterminer, pour chacun de la pluralité (200) de cycles de charge terminés, une valeur maximale (220mr-*) du paramètre lié à l'autonomie du véhicule obtenue pour les niveaux de charge associés sur l'ensemble des intervalles de regroupement (GI*) ;

un module de mesure de tendance centrale (140) adapté pour calculer, pour chaque niveau de charge, une première mesure de tendance centrale (200rct-*) des valeurs associées du paramètre lié à l'autonomie du véhicule dans chaque intervalle de regroupement ;

un module de dégradation intermédiaire de la batterie (150) adapté pour calculer, pour chaque niveau de charge associé (220b-*) dans chaque intervalle de regroupement (GI*), le rapport entre la première mesure de tendance centrale calculée respective et la valeur maximale respective des valeurs du paramètre lié à l'autonomie du véhicule, et pour déterminer une valeur de dégradation intermédiaire de la batterie par intervalle de regroupement pour chaque niveau de charge sur la base desdits rapports ; et

un module de dégradation de la batterie (160) adapté pour calculer, pour chaque intervalle de regroupement, une deuxième mesure de tendance centrale de toutes les valeurs intermédiaires de dégradation de la batterie sur l'ensemble des niveaux de charge dans l'intervalle de regroupement respectif (GI*), ce qui donne les valeurs de dégradation de la batterie (BDV*) pour chaque intervalle de regroupement.

10. Système selon la revendication 9, comprenant en outre :

un module de nettoyage des données (110) adapté pour supprimer les valeurs aberrantes et/ou les données de mauvaise qualité des valeurs de paramètres reçues en appliquant une méthode de nettoyage des données avant de fournir les données nettoyées au module de regroupement (120).

11. Système selon l'une quelconque des revendications 9 ou 10, comprenant en outre un module d'état de santé de la batterie (170) adapté pour :

obtenir des valeurs de dégradation de batterie de véhicules de flotte (BDV*) pour une pluralité (230) de véhicules électriques de flotte ayant un type de véhicule (T1) correspondant au véhicule électrique particulier (221), dans lequel les valeurs de dégradation de batterie de véhicules de flotte (BDV*) obtenues sont associées à des relevés de compteur kilométrique inférieurs à un seuil prédéfini indiquant un état de santé quasi parfait de la batterie respective ;

agréger (+) les valeurs de dégradation de batterie de véhicules de flotte (BDV*) obtenues appartenant à des intervalles de temps saisonniers respectifs (SI1, SI2, SI3), dans lequel chaque intervalle de temps saisonnier représente une période saisonnière correspondante de l'année, en déterminant une première mesure de tendance centrale de la valeur de dégradation de la flotte (BDF1, BDF2, BDF3) pour chaque intervalle de temps saisonnier (S11, SI2, S13) ;

calculer, pour le véhicule particulier (221), une mesure de tendance centrale de la valeur de dégradation de la batterie (MCTBDV_AT1) pour un intervalle de temps d'évaluation (AT1) ayant une durée qui est un multiple de la durée d'un intervalle de temps saisonnier ;

calculer, pour la pluralité (230) de véhicules électriques de la flotte, une deuxième mesure de tendance centrale de la valeur de dégradation de la flotte (MCTBDF_AT1) pour l'intervalle de temps d'évaluation (AT1), dans laquelle la deuxième mesure de tendance centrale de la valeur de dégradation de la flotte est basée sur la première mesure de tendance centrale des valeurs de dégradation de la flotte (BDF1, BDF2) des intervalles de temps saisonniers respectifs (SI1, SI2) ; et

déterminer la distance relative (-) entre la mesure de tendance centrale de la valeur de dégradation de la batterie (MCTBDV_AT1) et la deuxième mesure de tendance centrale de la valeur de dégradation de la flotte (MCTBDF_AT1) en tant que score d'état de santé (SOHS-221) de la batterie du véhicule électrique particulier (221).

**12.** Système selon l'une quelconque des revendications 9 à 11, dans lequel les mesures de tendance centrale sont choisies parmi : la moyenne, la médiane et le mode.

**13.** Système selon la revendication 10, dans lequel le nettoyage des données est adapté pour identifier ou marquer les données à nettoyer en utilisant une ou plusieurs des méthodes suivantes : des mesures de distance comprenant la distance de Mahalanobis et le score Z pour la détection des valeurs aberrantes, des méthodes d'estimation comprenant l'estimateur du déterminant de covariance minimale pour déterminer les valeurs aberrantes multivariées, et des algorithmes comprenant le facteur d'aberration local pour la détection des valeurs aberrantes multivariées et des algorithmes de regroupement comprenant DBSCAN et k-Means pour la détection des valeurs aberrantes par groupes.

**14.** Système selon l'une quelconque des revendications 9 à 13, dans lequel la valeur du paramètre lié à l'autonomie du véhicule est l'une des suivantes : une valeur d'autonomie fournie par le véhicule, un nombre de kWh en cours de charge pour atteindre ladite valeur du paramètre lié à l'autonomie, ou la tension, l'intensité et la durée utilisées pour la session de charge permettant de charger ledit nombre de kWh.

FIG. 1A

FIG. 1B

1000

receiving parameter sets associated with completed charging
runs of electric vehicle ⟍ 1100

applying data cleaning method ⟍ 1150

grouping range related parameter values by corresponding
charging levels within grouping intervals ⟍ 1200

determining maximum value of vehicle range related
parameter obtained for associated charging levels across all
grouping intervals ⟍ 1300

computing, for each charging level, a first measure of central
tendency of associated vehicle range related parameter values
in each grouping interval ⟍ 1400

computing, for each associated charging level in each grouping
interval, the ratio of the respective computed first measure of
central tendency to the respective maximum value of vehicle
range related parameter values ⟍ 1500

determining intermediate battery degradation value by
grouping interval for each charging level ⟍ 1600

computing, for each grouping interval, a second measure of
central tendency of all intermediate battery degradation values
across all charging levels in the respective grouping interval
resulting in the battery degradation values for each grouping
interval ⟍ 1700

determining state-of-health score of battery of electric vehicle ⟍ 1800

FIG. 2A

1800

obtaining fleet vehicle battery degradation values for a plurality of electric fleet vehicles corresponding to the type of said electric vehicle ⌐ 1810

aggregating obtained fleet vehicle battery degradation values belonging to respective seasonal time intervals by determining a first measure of central tendency fleet degradation value for each seasonal time interval ⌐ 1820

computing, for the particular vehicle, a measure of central tendency battery degradation value for an assessment time interval ⌐ 1830

computing, for the electric fleet vehicles, a second measure of central tendency fleet degradation value for the assessment time interval, based on the corresponding the first measure of central tendency fleet degradation values ⌐ 1840

determining relative distance between the measure of central tendency battery degradation value and the second measure of central tendency fleet degradation value as vehicle state-of-health score of the battery of said electric vehicle ⌐ 1850

# FIG. 2B

300

```
{
> '85000': {…
  },
  '86000': {
    '68': [ 212, 212 ],
    '69': [ 212, 212, 215 ],
    '70': [ 213, 213 ],
  '87000': {
    '58': [ 212 ],
    '68': [ 212 ],
    '69': [ 212, 214, 215 ],
    '85': [ 213, 213 ],
    '88': [ 213 ],
    '89': [ 211.33333333333334, 212 ],
    '90': [ 212 ],
    '91': [ 212 ],
    '92': [ 212 ],
    '94': [ 213 ],
    '95': [ 213 ],
    '96': [ 213 ],
    '97': [ 212 ]
  },
  '88000': {
    '69': [ 212, 220, 230 ],
    '84': [ 212 ],
  },
> '89000': {…
  },
> '90000': {…
  },
> '91000': {…
```

CL68 — RV212 — RV215 — CL69 — CL70 — RV213

GI86 — GI87 — GI88

# FIG. 3

FIG. 4A

40o

V41-VT1

40d

FIG. 4B

V42-VT2

1800

FIG. 4C

FIG. 4D

FIG. 5

FIG. 6

FIG. 7

FIG. 8